# EUROPEAN PATENT APPLICATION

(11) **EP 4 425 364 A1**
(43) Date of publication of application: **04.09.2024**
(21) Application number: 22886581.2
(22) Date of filing: 29.09.2022
(51) Int. Cl.: G06F 30/12, G06F 30/20

(54) **PROGRAM AND SYSTEM FOR SIMULATION**

(30) Priority: 27.10.2021 JP 2021175328
(71) Applicant: OMRON Corporation, Kyoto 600-8530 (JP)
(72) Inventor: HASEGAWA, Naoto, Kyoto-shi, Kyoto 600-8530 (JP); IWAMURA, Shintaro, Kyoto-shi, Kyoto 600-8530 (JP); OHNUKI, Haruna, Kyoto-shi, Kyoto 600-8530 (JP)
(74) Representative: Mewburn Ellis LLP
(86) International application number: PCT/JP2022/036480
(87) International publication number: WO 2023/074249

(57) **Abstract**

A technique for easily adjusting a coupling relationship between components in a simulation is provided. A program for a simulation causes a computer (300) to: obtain a plurality of pieces of component data of an assembly; generate a coupling setting between pieces of component data of the plurality of pieces of component data; receive an operation input from a user; adjust the coupling setting based on the operation input from the user; emulate, based on a user program, a controller configured to control the assembly; and operate the assembly in a three-dimensional (3D) space. Operating the assembly includes operating, based on the adjusted coupling setting, the pieces of component data of the plurality of pieces of component data in conjunction with each other.

## Description

### TECHNICAL FIELD

The present disclosure relates to a simulation of a machine, and more particularly, to a technique for coupling settings of an assembly for use in a simulation.

### BACKGROUND ART

Conventionally, three-dimensional computer aided design (3D CAD) software for machine design has been known. In the 3D CAD software, a machine can be represented as an assembly composed of a plurality of components. The plurality of components included in the assembly are defined in terms of their relative positions and coupling relationship (also referred to as, for example, restraint relationship or connection relationship). The 3D CAD software can also generate CAD data as data including one or more machine components (parts), one or more assemblies, or both of them.

Further, in recent years, a simulation or the like of a production line has been performed in factory automation (FA) using CAD data of a machine designed by 3D CAD software. Some pieces of simulation software have a function of linking with a controller emulator that virtually represents a programmable logic controller (PLC) or the like. In a simulation using such CAD data, a technique is desired for easily extracting the coupling relationship of, and setting a motion of, components included in an assembly.

Regarding the technique of extracting the coupling relationship of CAD data, for example, Japanese Patent Laying-Open No. 2001-202393 (PTL 1) discloses a method and a device for extracting a component connection relationship. The method and the device "select a representative point from a target component, and detect a connection relationship between the target component and any other component by finding an intersection with a straight line projected in the direction of each coordinate axis. The method and the device also efficiently extract a connection relationship by grouping or the like, not by testing components in a round robin manner" (see [Abstract]).

Also, another technique of extracting a coupling relationship of CAD data is disclosed in, for example, Japanese Patent Laying-Open No. 2006-190183 (PTL 2).

### CITATION LIST

### PATENT LITERATURE

PTL 1: Japanese Patent Laying-Open No. 2001-202393
PTL 2: Japanese Patent Laying-Open No. 2006-190183

### SUMMARY OF INVENTION

### TECHNICAL PROBLEM

The techniques disclosed in PTLs 1 and 2 have a main object to extract a coupling relationship between components or check interference between components. These techniques thus fail to adjust a setting of the coupling relationship between components to implement a motion of the entire machine in a simulation. This requires a technique for easily adjusting a coupling relationship between components to implement a motion of the entire machine in a simulation.

The present disclosure has been made in view of the above circumstances. An object in an aspect of the present disclosure is to provide a technique for easily adjusting a coupling relationship between components to implement a motion of the entire machine in a simulation.

### SOLUTION TO PROBLEM

According to an embodiment, a program for a simulation is provided. The program causes a computer to: obtain a plurality of pieces of component data of an assembly; generate a coupling setting between pieces of component data of the plurality of pieces of component data; receive an operation input from a user; adjust the coupling setting based on the operation input from the user; emulate, based on a user program, a controller configured to control the assembly; and operate the assembly in a three-dimensional (3D) space. Operating the assembly includes operating, based on the adjusted coupling setting, the pieces of component data of the plurality of pieces of component data in conjunction with each other.

According to the present disclosure, the program can generate the coupling setting between pieces of component data of the plurality of pieces of component data and receive a change input of the coupling setting from the user. This allows the user to also set a coupling relationship, which is difficult to determine only from the geometry of the component data, as appropriate.

In the disclosure above, adjusting the coupling setting includes selecting a type of coupling between the pieces of component data of the plurality of pieces of component data, adjusting a coupling point, and setting a direction of motion of a first component included in the plurality of pieces component data.

According to the present disclosure, the program can provide the user with means for changing the type of the coupling relationship, the adjustment of a coupling point, and the setting of the direction of motion of the first component included in the plurality of pieces of component data.

In the disclosure above, the program further causes the computer to snap, on a screen configured to receive the operation input from the user, a cursor to a location of each of the plurality of pieces of component data in the 3D space.

According to the present disclosure, the program can provide a snapping mode in the 3D space. The user can use the snapping mode to easily put the cursor to a specific location (e.g., an edge, the center of a hole) of the component.

In the disclosure above, the program further causes the computer to receive an input of an amount of movement of the assembly. Operating the assembly includes operating, on a screen for a test operation of the assembly, each of the plurality of pieces of component data in the 3D space upon input of the amount of movement of the assembly.

According to the present disclosure, the program can provide the function of receiving an input of an amount of movement of the movable component and the function of simulating a motion of the assembly based on the input of the amount of movement of the movable component. The user can adjust the amount of movement of the movable component so as not to break the assembly while checking a simulation screen.

In the disclosure above, the program further causes the computer to receive a setting of each of a plurality of interfaces of the controller. The setting of each of the plurality of interfaces includes a setting of a device, a machine, or a sensor connected with each of the plurality of interfaces. Emulating the controller includes emulating an input/output signal of each of the plurality of interfaces based on the setting of each of the plurality of interfaces.

According to the present disclosure, the program can receive the setting of the interface of the controller to coordinate the emulator of the controller with the physical engine that executes a simulation. This allows the user to perform a motion simulation of the assembly using the user program.

In the disclosure above, the program further causes the computer to receive a motion setting of a motor driver controlled by the controller. Emulating the controller includes outputting an instruction corresponding to the motion setting from the controller to the motor driver.

According to the present disclosure, the program can receive the motion setting of the motor driver in advance. This allows the controller to operate the assembly via the motor driver and the motor in the simulation.

In the disclosure above, the program further causes the computer to receive an input of a setting of a virtual sensor. The setting of the virtual sensor includes information on placement of the virtual sensor in the 3D space, and information on connection between the virtual sensor and an interface of the controller. Emulating the controller includes emulating an input signal of the virtual sensor in the controller based on the setting of the virtual sensor.

According to the present disclosure, the program enables a simulation using the virtual sensor. The user can use the virtual sensor to reproduce an environment closer to reality in the 3D space.

In the disclosure above, the program further causes the computer to display an execution result of the user program by an emulation and an execution result of a simulation. Displaying the execution result of the user program by the emulation and the execution result of the simulation includes displaying an execution result of each step of the user program and an execution result of a simulation corresponding to each step of the user program.

According to the present disclosure, the program can present, to the user, the execution result of the user program and the execution result of the simulation. The user can check a value of a variable of the user program and a motion of the assembly to easily understand a problem with the user program or the assembly.

In the disclosure above, the program further causes the computer to receive an input to set a breakpoint in the user program, and display an execution result of a simulation corresponding to the breakpoint upon stop of the user program at the breakpoint.

According to the present disclosure, the program can pause replay of a simulation according to the breakpoint. This allows the user to check a motion of the assembly at or immediately before execution of a code where a problem has presumably occurred.

According to another embodiment, a simulation system for a motion of an assembly is provided. The simulation system includes: a component acquisition unit configured to obtain a plurality of pieces of component data of an assembly; an automatic coupling unit configured to generate a coupling setting between pieces of component data of the plurality of pieces of component data; an operation input unit configured to receive an operation input from a user; a coupling adjustment unit configured to adjust the coupling setting based on the operation input from the user; an emulator of a controller configured to control the assembly based on a user program; and a physical engine configured to operate the assembly in a three-dimensional (3D) space. The physical engine operates, based on the coupling setting adjusted by the coupling adjustment unit, the pieces of component data of the plurality of pieces of component data in conjunction with each other.

According to the present disclosure, the simulation system can generate the coupling setting between pieces of component data of the plurality of pieces of component data and receive a change input of the coupling setting from the user. This allows the user to also set a coupling relationship, which is difficult to determine only from the geometry of the component data, as appropriate.

In the disclosure above, adjusting the coupling setting includes selecting a type of coupling between the pieces of component data of the plurality of pieces of component data, adjusting a coupling point, and setting a direction of motion of a first component included in the plurality of pieces of component data.

According to the present disclosure, the simulation system can provide the user with means for changing the type of the coupling relationship, adjustment of the coupling point, and the setting of the direction of motion of the first component included in the plurality of pieces of component data.

In the disclosure above, the operation input unit is configured to snap a cursor to a location of each of the plurality of pieces of component data in the 3D space.

According to the present disclosure, the simulation system can provide a snapping mode in the 3D space. The user can use the snapping mode to easily put a cursor to a specific location (e.g., an edge, the center of a hole) of the component.

In the disclosure above, the operation input unit receives an input of an amount of movement of the assembly. The physical engine is configured to operate, on a screen for a test operation of the assembly, each of the plurality of pieces of component data in the 3D space upon input of the amount of movement of the assembly.

According to the present disclosure, the simulation system can provide the function of receiving an input of an amount of movement of the movable component and the function of simulating a motion of the assembly based on the input of the amount of movement of the movable component. The user can adjust the amount of movement of the movable component so as not to break the assembly while checking a simulation screen.

In the disclosure above, the operation input unit is configured to receive a setting of each of a plurality of interfaces of the controller. The setting of each of the plurality of interfaces includes a setting of a device, a machine, or a sensor connected with each of the plurality of interfaces. The emulator is configured to emulate an input/output signal of each of the plurality of interfaces based on the setting of each of the plurality of interfaces.

According to the present disclosure, the simulation system can receive the setting of the interface of the controller to coordinate the emulator of the controller with the physical engine that executes a simulation. This allows the user to perform a motion simulation of the assembly using the user program.

In the disclosure above, the operation input unit is further configured to receive a motion setting of a motor driver controlled by the controller. The emulator is configured to output an instruction corresponding to the motion setting from the controller to the motor driver.

According to the present disclosure, the simulation system can receive the motion setting of the motor driver in advance. This allows the controller to operate the assembly via the motor driver and the motor in the simulation.

In the disclosure above, the operation input unit is configured to receive an input of a setting of a virtual sensor. The setting of the virtual sensor includes information on placement of the virtual sensor in the 3D space, and information on connection between the virtual sensor and an interface of the controller. The emulator is configured to emulate an input signal of the virtual sensor in the controller based on the setting of the virtual sensor.

According to the present disclosure, the simulation system enables a simulation using the virtual sensor. The user can use the virtual sensor to reproduce an environment closer to reality in the 3D space.

In the disclosure above, the simulation system further includes a display unit configured to display an execution result of the user program by the emulator and an execution result of a simulation by the physical engine. The display unit is configured to display an execution result of each step of the user program and an execution result of a simulation corresponding to each step of the user program.

According to the present disclosure, the simulation system can present, to the user, the execution result of the user program and the execution result of the simulation. The user can check a value of a variable of the user program and a motion of the assembly to easily understand a problem with the user program or the assembly.

In the disclosure above, the operation input unit is configured to receive an input to set a breakpoint in the user program. The display unit is configured to display an execution result of a simulation corresponding to the breakpoint upon stop of the user program at the breakpoint.

According to the present disclosure, the simulation system can pause replay of a simulation according to the breakpoint. This allows the user to check a motion of the assembly at or immediately before execution of a code where a problem has presumably occurred.

### ADVANTAGEOUS EFFECTS OF INVENTION

According to an embodiment, a coupling relationship between components can be easily adjusted to implement a motion of the entire machine in a simulation.

The foregoing and other objects, features, aspects and advantages of the present disclosure will become more apparent from the following detailed description of the present disclosure when taken in conjunction with the accompanying drawings.

### BRIEF DESCRIPTION OF DRAWINGS

Fig. 1 shows example CAD data of a machine whose motion can be simulated by a program, a system, or a method according to an embodiment.
Fig. 2 schematically shows example functions of a system 100 according to an embodiment.
Fig. 3 shows an example device 300 of system 100.
Fig. 4 shows an example coupling setting screen.
Fig. 5 shows an example snapping mode on the coupling setting screen.
Fig. 6 shows a first setting example on the coupling setting screen.
Fig. 7 shows a second setting example on the coupling setting screen.
Fig. 8 shows a third setting example on the coupling setting screen.
Fig. 9 shows a fourth setting example on the coupling setting screen.
Fig. 10 shows an example motion direction setting screen.
Fig. 11 shows a first setting example on the motion direction setting screen.
Fig. 12 shows a second setting example on the motion direction setting screen.
Fig. 13 shows a third setting example on the motion direction setting screen.
Fig. 14 shows an example assembly test operation screen.
Fig. 15 shows an example use of the assembly test operation screen.
Fig. 16 shows example coupling settings set in system 100.
Fig. 17 shows an example simulation execution screen.
Fig. 18 shows an example motor driver setting screen.
Fig. 19 shows a first example of a debug screen of a user program.
Fig. 20 shows a second example of the debug screen of the user program.
Fig. 21 shows an example virtual sensor setting screen.
Fig. 22 is a flowchart showing an example series of processes from generation of various settings to execution of a simulation in system 100.
Fig. 23 is a flowchart showing an example procedure of a simulation using a virtual sensor in system 100.

### DESCRIPTION OF EMBODIMENTS

Embodiments of a technical idea according to the present disclosure will be described below with reference to the drawings. In the description below, the same elements have the same reference characters allotted, and their labels and functions are also the same. Therefore, detailed description thereof will not be repeated.

### <A. Example of Application>

A technique according to the present disclosure relates to a program, a system, and a method for, for example, obtaining CAD data of a machine designed using 3D CAD software and linking a controller emulator that virtually represents PLC or the like with a physical engine, thereby simulating an obtained motion of the machine.

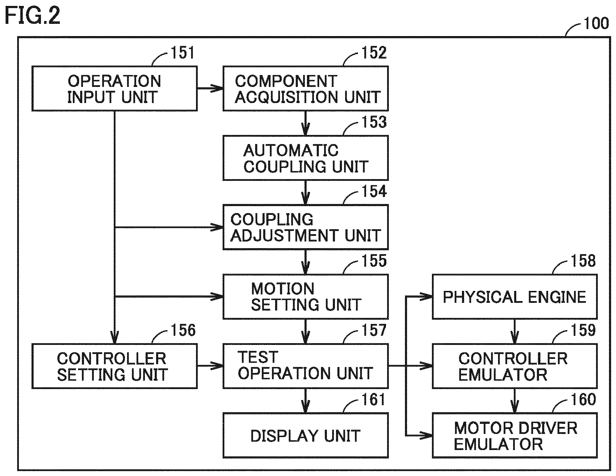

In an aspect, the technique of the present disclosure may be implemented, for example, as a distributable program (e.g., integrated development environment 130) that can include functions described with reference to Fig. 2 and the following figures. In this case, a program that provides the technique of the present disclosure can be executed on, for example, any hardware such as device 300.

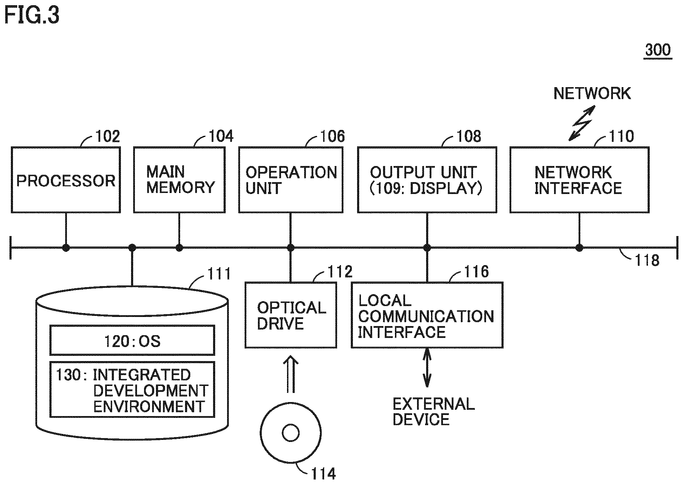

In another aspect, the technique of the present disclosure may be implemented, for example, as a system with the functions described with reference to Fig. 2 and the following figures. In this specification, the term "system" encompasses a configuration composed of one or more devices that provide a function of simulating a machine motion. Although the following will mainly describe an example of a system 100 (see Fig. 2) mainly composed of a device 300 (see Fig. 3) that provides integrated development environment 130, the present disclosure is not limited thereto. A plurality of devices may be linked to provide the function of simulating a machine motion.

System 100 may be implemented as a cloud environment, a service on a cloud environment, an instance, or a virtual machine. In this case, hardware of a data center that implements the cloud environment may be implemented by a plurality of devices 300, or may be implemented by any combination of pieces of hardware of device 300.

The user may use the function of system 100 via a browser function of a user terminal or an application installed in the user terminal, or directly use a device that operates as system 100. Further, system 100 may include one or more controllers, such as PLCs. In this case, the function of simulating a machine motion may be provided to a controller.

Although the following will describe system 100 that implements the technique of the present disclosure by way of example, a motion of system 100 may be read as a motion implemented by cooperation of a program (integrated development environment 130), which implements the technique of the present disclosure, with hardware.

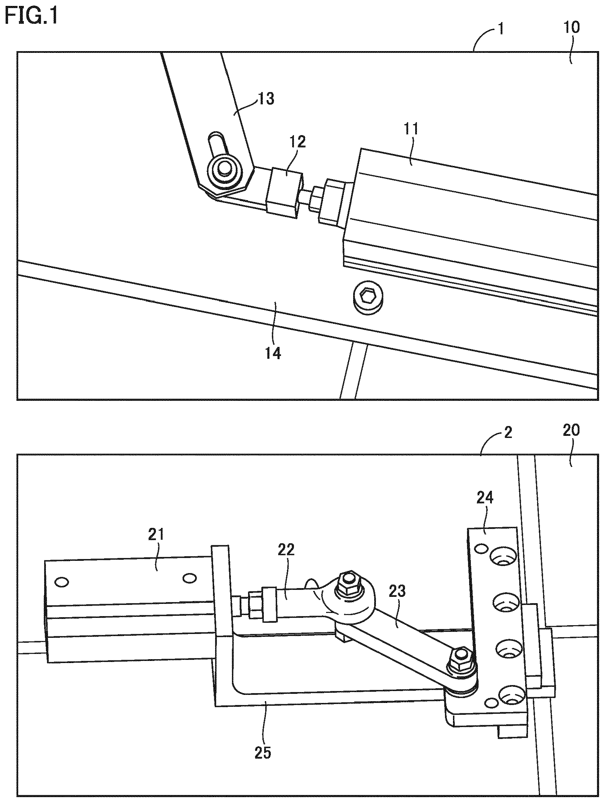

Fig. 1 shows example CAD data of a machine whose motion can be simulated by a program, a system, or a method according to the present embodiment.

### (a. Coupling Relationship in CAD Data)

CAD data 1 and CAD data 2 are examples of CAD data of a machine whose motion can be simulated by system 100. First, a coupling relationship that can be included in CAD data will be described by taking CAD data 1 and CAD data 2 as examples.

CAD data 1 includes an assembly 10. Assembly 10 includes a component 11, a component 12, a component 13, and a component 14 as main components. Component 11 is fixed to component 14. Component 12 linearly moves relative to component 11. Component 13 is rotatably connected at an end thereof to component 12 with a bolt, and the end of component 13 moves according to the linear motion of component 12. In other words, assembly 10 can move component 13 with the use of a linear motion of component 12. For example, component 13 is part of a link and can transfer power obtained from component 12 to any other component in another form.

CAD data 2 includes an assembly 20. Assembly 20 includes a component 21, a component 22, a component 23, a component 24, and a component 25 as main components. Component 21 is fixed to component 25. Component 22 moves linearly relative to component 21. Component 23 is rotatably connected at an end thereof to component 22 with a bolt. Component 23 is also rotatably connected at another end thereof to component 24 with a bolt. Component 24 is connected to component 25 via a rail and can move in parallel to component 25. Assembly 20 moves the end of component 23 toward component 24 with the use of the linear motion of component 22. Thus, component 24 is pushed by the other end of component 23 to slide relative to component 25.

When CAD data includes a plurality of components (when CAD data includes an assembly) as described above, it may include a coupling relationship between the components. "Coupling relationship" can include a relative position of one component to any other component and a type of coupling. The relative position (which may be absolute coordinates) can be defined by the coordinates of components in a 3D space, or a positional relationship of specific portions of the components. The type of coupling can be defined by a motion of a component to any other component or a method of fixing a component to any other component. For example, component 11 is fixed to a surface of component 14. In other words, the type of coupling between component 11 and component 14 is "fixing". In any other example, component 12 can move linearly relative to component 11. In other words, the type of coupling between component 11 and component 14 is "slider joint". In still another example, component 13 is rotatable about a bolt (bolt hole) relative to component 12. In other words, the type of coupling between component 13 and component 12 is "hinge joint".

3D CAD software records a history of an assembly or a component when it was designed. Thus, CAD data can also hold a coupling relationship between components. However, when CAD data is exported from 3D CAD software and imported into any other software (e.g., integrated development environment 130 or the like), the history may be lost. It is therefore desirable to generate a coupling relationship between components from the shape of each component included in an assembly without relying on a format of specific 3D CAD software.

However, an accurate coupling point and an accurate type of coupling may not always be determined from the shape of each component included in an assembly. Thus, system 100 provides some functions including a function of adjusting a coupling relationship between components in order to simulate any assembly motion. Next, the functions provided by system 100 will be described.

### (b. Functions Provided by Program or System of the Present Disclosure)

System 100 may provide, as main functions, a coupling setting function, a component motion direction setting function, an assembly test operation function, a controller setting function, a simulation function, and a debug function. "Coupling setting" can include any information on a coupling relationship between components. For example, the coupling setting includes at least some of a coupling point (a point, a position, or coordinates where two components having a coupling relationship are coupled), a type of coupling, a direction of motion (a direction of motion of a movable component), and an amount of movement (a limit amount of movement of, or a range of movement of, a movable component).

The coupling setting function can include a function of adjusting a coupling point between components and a function of selecting a type of coupling between components. The "function of adjusting a coupling point between components" is a function of adjusting a coupling point (coordinates) of two components having a coupling relationship. The coupling point may include a plurality of coordinates (to represent an axis of rotation, a direction of sliding, and the like). For example, the function of adjusting a coupling point between components can include selecting bolt holes of component 22 and component 23 as an axis of rotation of a hinge joint, adjusting fixing surfaces (e.g., an offset value) of component 11 and component 14, and the like. The function of adjusting a coupling point between components may include adjusting the position of each component by moving the component. The "function of selecting a type of coupling between components" is a function of selecting the type of coupling (e.g., fixing, hinge joint, pole joint, slider joint) between two components having a coupling relationship. In an aspect, the coupling setting function may include the function of setting the direction of movement of a first component and may not include the function of setting the range (limit amount of movement) in which the first component is movable. In another aspect, the coupling setting function may include the function of setting the direction of movement of the first component and the function of setting a range (limit amount of movement) in which the first component is movable.

System 100 can automatically generate coupling settings between components based on the shape of each component and the positional relationship between components which are included in imported CAD data (or intermediate data such as STEP file). However, coupling settings may not be generated accurately only from the shape of a component. For example, components 11, 12 overlap each other as viewed from system 100 that does not manage the history, and accordingly, it may not be determined whether component 11 is fixed to component 12 or component 11 is linearly movable relative to component 12. When component 12 is an assembly of a plurality of components, a combination of which components is linearly movable relative to component 11 may not be determined.

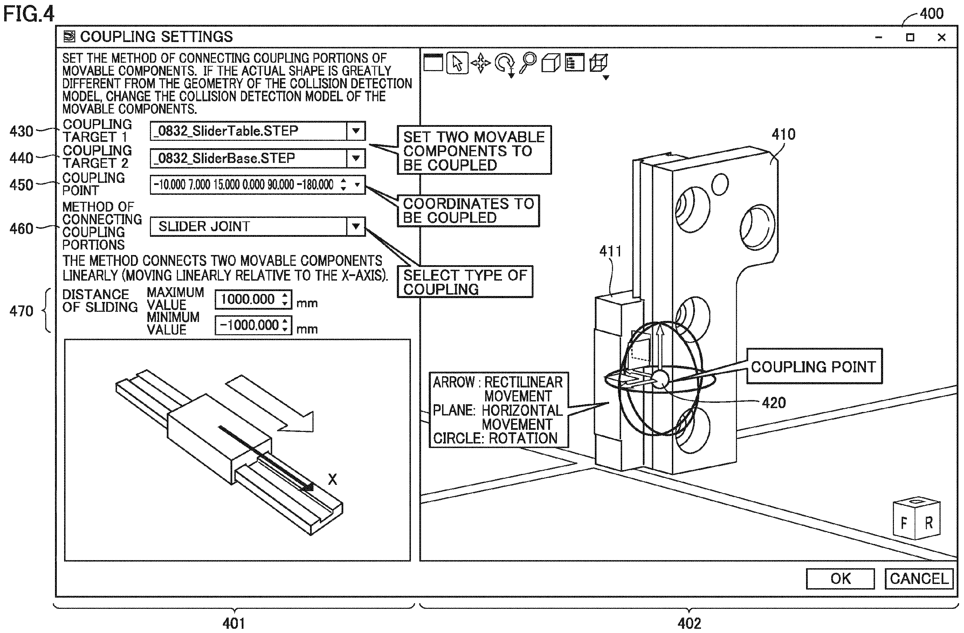

Thus, the user can use the coupling setting function via a user interface (UI), provided by system 100, to adjust a coupling point and select a type of coupling. For example, accurate coupling settings can be generated with fewer man-hours for any assembly imported into system 100 as system 100 automatically generates coupling settings when coupling settings can be easily generated based on the shape of a component, or otherwise, the user input coupling settings. The coupling setting function and the UI therefor will be described later in detail with reference to Figs. 4 to 9.

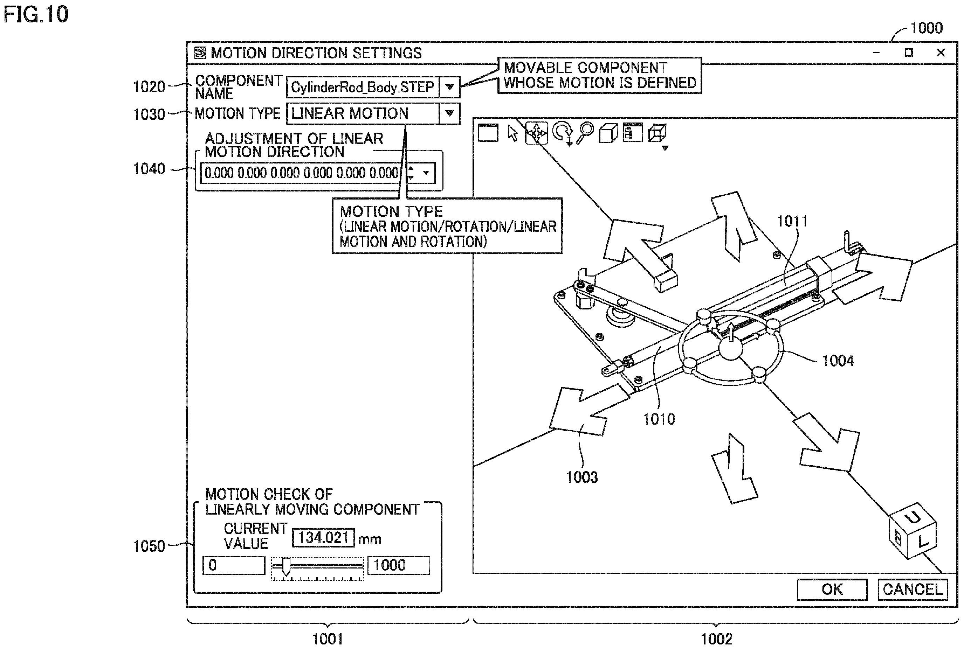

The component motion direction setting function can include the function of setting a direction of motion of a first component (movable component). For example, the user can set a direction of motion (direction of sliding) of component 11 (movable component) via the UI provided by system 100. Some assemblies may perform a complicated combined motion including linear motion and rotation. The user can also perform motion setting on the assembly including such a complicated motion via the UI provided by system 100. The component motion direction setting function and the UI therefor will be described later in detail with reference to Figs. 10 to 13.

The assembly test operation function is a function of verifying a motion of an assembly based on a coupling point between components, a type of coupling between components, and settings of a direction of motion of a component. Operating an assembly includes operating, based on the adjusted coupling settings, pieces of component data in conjunction with each other. For example, the user can verity a motion of a mechanism of part of an FA production line, such as assembly 10 or assembly 20, via the UI (e.g., a simulation screen, a motion UI, and the like) provided by system 100.

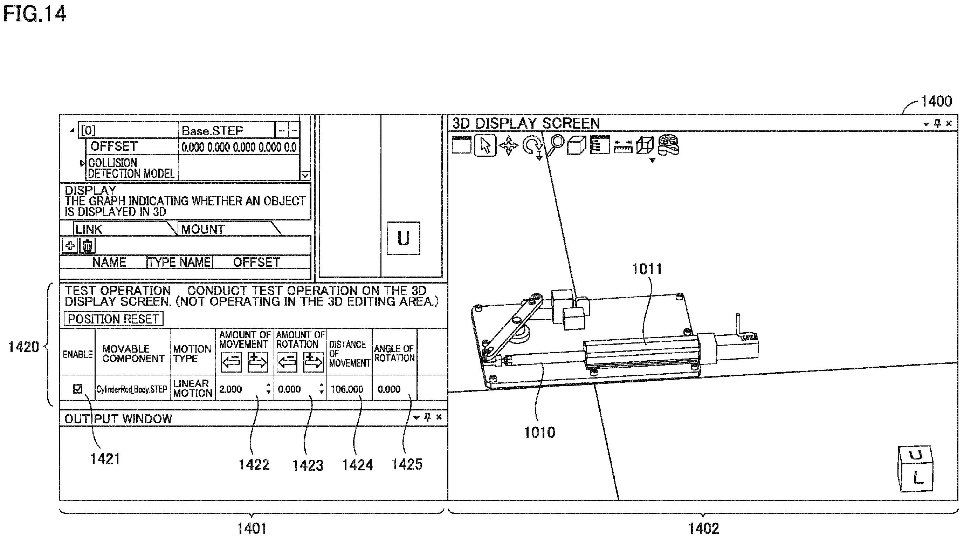

Also, the user can check a limit of an amount of movement of each component by using the assembly test operation function. In one example, it is assumed that the user slides component 22 via the UI provided by system 100. In this case, system 100 also slides component 24 using the function of the physical engine. If the distance by which component 24 is slidably movable is shorter than the distance by which component 22 is slidably movable, as component 22 slides beyond the limit amount of movement of component 24, each component of assembly 20 will be overloaded. In this case, the UI of system 100 outputs, to a simulation screen, a depiction in which components are uncoupled from each other or a depiction in which coupling between components is broken. The user can check an assembly appearing on the simulation screen to check a limit amount of movement. The assembly test operation function and the UI therefor will be described later in detail with reference to Figs. 14 to 16.

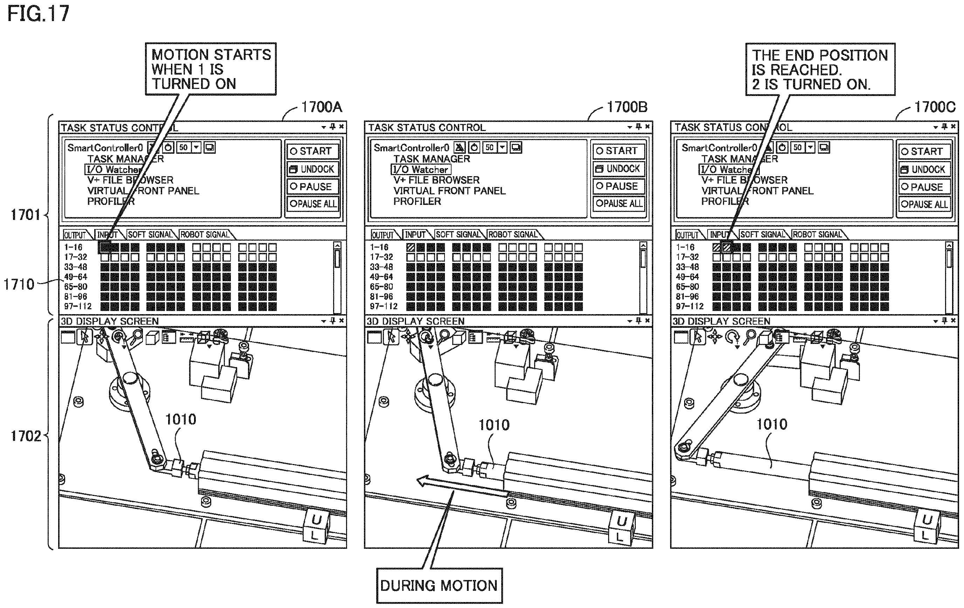

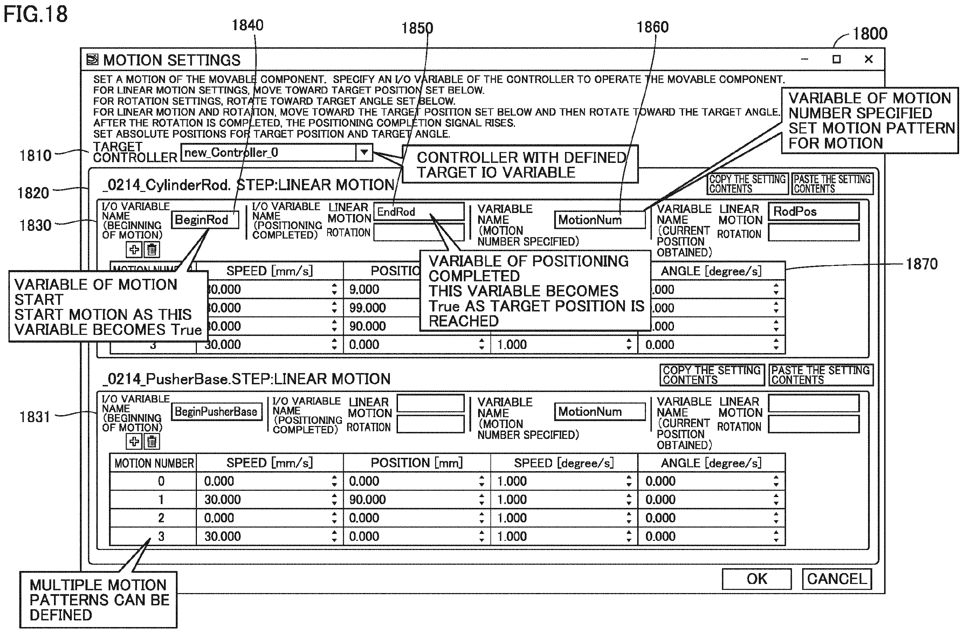

The controller setting function is a function for setting a controller and a driver that control each machine in the FA production line. In the FA production line, the controller such as a PLC usually sends a command to a motor driver. The motor driver outputs a driving signal to a motor based on the received command. Then, as the motor is driven, the assembly attached to the motor also operates. In order to simulate a series of motions described above with the physical engine and the controller emulator coordinated with each other, the user can perform IO setting of the controller and the motor driver, motion setting for each motor driver, or the like via the UI provided by system 100. The user can coordinate the controller emulator with the physical engine by, for example, performing IO setting of the controller using the controller setting function. The controller setting function and the UI therefor will be described later in detail with reference to Figs. 17 and 18.

The simulation function is a function of performing a simulation with the controller emulator and the physical engine coordinated with each other. More specifically, the user installs a developed user program on the controller emulator. The controller emulator outputs a signal from the IO based on the user program. The simulator simulates a motion of the motor based on the signal from the controller emulator and drives the assembly. Thus, the user can check whether the production line operates properly based on the user program developed by the user.

The debug function is a function for debugging a user program to be installed on the controller. System 100 can perform a simulation in conjunction with a step of the user program. In an aspect, system 100 may provide the function of executing a step of a user program.

System 100 can display, on the UI, the value of each variable of the user program and a simulation screen that correspond to each step. For each step, the user can compare the simulation screen (movement of an assembly) with the value of a variable to debug a user program. One example of the variable included in the user program may be an international electrotechnical commission (IEC) variable.

In an aspect, the debug function may include a breakpoint setting function. When a breakpoint is set in the user program, as the user program is executed to the breakpoint, the simulation execution screen also pauses at a scene corresponding to the breakpoint. Starting from the breakpoint, the user can perform stepwise execution of the user program to understand what has happed before and after the breakpoint.

As described above, system 100 can provide the coupling setting function, the component motion direction setting function, and the assembly test operation function, thereby verifying a motion of the assembly. System 100 can also provide the controller setting function, the simulation function, and the debug function, thereby operating an assembly using the user program.

### <B. System Configuration>

Next, an example function and an example hardware configuration of system 100 according to the present embodiment will be described with reference to Figs. 2 and 3.

Fig. 2 schematically shows example functions of system 100 according to an embodiment. In an aspect, each function shown in Fig. 2 may be implemented as a program module. In another embodiment, each function shown in Fig. 2 may be implemented as part of the function of integrated development environment 130. In such cases, each function shown in Fig. 2 can be implemented as a program (e.g., integrated development environment 130 or any other program) is executed by device 300. Further, in still another aspect, part of each function shown in Fig. 2 may be implemented by, for example, at least one field programmable gate array (FPGA), application specific integrated circuit (ASIC), or a combination thereof.

System 100 includes an operation input unit 151, a component acquisition unit 152, an automatic coupling unit 153, a coupling adjustment unit 154, a motion setting unit 155, a controller setting unit 156, a test operation unit 157, a physical engine 158, a controller emulator 159, a motor driver emulator 160, and a display unit 161.

Operation input unit 151 receives various operation inputs from the user via the UI provided by system 100. In one example, operation input unit 151 can include an operation of importing CAD data, an operation of adjusting a coupling point between components, an operation of selecting a type of coupling between components, an operation of setting a direction of motion of a component, an operation of setting an amount of motion of a component, an operation of executing a test operation of an assembly, an operation of setting a controller, an operation of performing a simulation with physical engine 158 and controller emulator 159 coordinated with each other, a debugging operation, and any other operation.

Component acquisition unit 152 imports CAD data into system 100 based on the operation of importing CAD data or intermediate data by the user. In an aspect, component acquisition unit 152 may import a CAD file of any 3D CAD software or import an intermediate file such as IGES, STEP, or Parasolid.

Automatic coupling unit 153 automatically generates coupling settings between components based on the shape and the position of each component included in the CAD data imported into system 100.

Coupling adjustment unit 154 changes the coupling settings between components generated by automatic coupling unit 153 based on a user's operation. More specifically, automatic coupling unit 153 can perform the processes of adjusting a coupling point between components and selecting a type of coupling between components. In an aspect, the user may define all the coupling settings between components using the function of coupling adjustment unit 154 without using the function of automatic coupling unit 153.

Motion setting unit 155 sets a direction of motion of a component based on a user's operation. For example, when there are a first component and a second component having a coupling relationship and when the first component is a movable component, motion setting unit 155 can set a direction of motion of the first component. In one aspect, motion setting unit 155 may set an amount of motion of a component based on a user's operation. For example, motion setting unit 155 can set a limit amount of motion or a motion range of the first component.

Controller setting unit 156 can set a controller and a motor driver based on a user's operation. For example, setting of a controller and setting of a motor driver can include an IO setting. The IO setting can include information on equipment connected to a port. The setting of the motor driver can include a motion setting how to drive a motor. The motor driver receives a command corresponding to the motion setting from the controller to output a signal based on the motion setting to the motor.

Test operation unit 157 provides a function of simulating a motion of a single assembly, a simulation function with physical engine 158 and controller emulator 159 coordinated with each other, and a debug function.

Physical engine 158 renders an object in a 3D space. Physical engine 158 also calculates a movement of each object, a force applied to each object, or the like. Physical engine 158 is invoked by test operation unit 157.

Controller emulator 159 emulates an operation of a controller such as a PLC. Controller emulator 159 can also interpret and execute a user program similarly to an actual controller. Test operation unit 157 delivers data between physical engine 158 and controller emulator 159. For example, test operation unit 157 can deliver a signal output from the controller, a signal output from a sensor, or the like.

Motor driver emulator 160 emulates an operation of a motor driver such as a servomotor or a stepping motor. In an aspect, motor driver emulator 160 may be part of physical engine 158 or controller emulator 159.

Display unit 161 outputs various UIs provided by system 100, a simulation execution screen, a user program execution screen, and the like. In an aspect, the UI provided by system 100 can include all or some of various operation items, the simulation execution screen, and the user program execution screen.

Fig. 3 shows an example device 300 of system 100. Device 300 is an information processor such as a computer and can operate as system 100. In an aspect, system 100 may be implemented by one or more devices 300, a system including at least part of the hardware configuration of device 300, a virtual machine on a cloud environment including at least part of the hardware configuration of device 300, or the like.

Device 300 includes, as main components, a processor 102 that executes an operating system (OS) and a program operated on the OS, a main memory 104 that provides a work area for storing data required for execution of a program by processor 102, an operation unit 106 (operation reception unit) that receives a user operation performed on a keyboard, a mouse, or the like, an output unit 108 that outputs a processing result, such as a display 109, various indicators, a printer, and the like, a network interface 110 connected to various networks, an optical drive 112, a local communication interface 116 that communicates with an external device, and a storage 111. These components are connected so as to perform data communications via an internal bus 118 or the like.

Device 300, which includes optical drive 112, may read various programs from a computer-readable recording medium 114 including an optical recording medium (e.g., digital versatile disc (DVD) or the like) that non-transitorily stores a computer-readable program and install the various programs on storage 111 or the like.

Various programs executed by device 300 can be installed on device 300 via computer-readable recording medium 114. In another aspect, the program may be installed on device 300 from a server device (not shown) or the like on a network via network interface 110.

Storage 111 is configured of hard disk drive (HDD), a solid state drive (flash SSD), or the like, and stores a program executed by processor 102. More specifically, storage 111 stores an OS 120 and integrated development environment 130. Integrated development environment 130 can be implemented as an application operating on OS 120.

Integrated development environment 130 provides the functions of system 100 according to the present embodiment. In other words, the functions of system 100 can be implemented as processor 102 executes integrated development environment 130 deployed in main memory 104.

### <C. Coupling Settings>

Next, the coupling setting function and the UI therefor, which are provided by system 100, will be described with reference to Figs. 4 to 9. The user can adjust a coupling point between components and select a type of coupling via a coupling setting screens described with reference to Figs. 4 to 9. Further, the user can also set an amount of movement (range of movement) of the first component (movable component) via the coupling setting screen. The user may also adjust a position of each component included in an assembly via the coupling setting screen.

Fig. 4 shows an example coupling setting screen. A coupling setting screen 400 includes a coupling setting input panel 401 and a 3D display screen 402. 3D display screen 402 displays a tool 420 for setting a coupling point between a first component 410 and a second component 411. The user can operate (e.g., rotate or translate) tool 420 with a mouse or the like to adjust the coordinates of the coupling point.

Coupling setting input panel 401 relates to the coupling settings of first component 410 and second component 411. Coupling setting input panel 401 includes, as setting items, a coupling target 1_430, a coupling target 2_440, a coupling point 450, a method of connecting coupling portions 460, and a distance of movement 470.

Coupling target 1_430 is an item for selecting first component 410 to be coupled. For example, the user may select pull-down of coupling target 1_430 and select first component 410 from a list, or select CAD data of first component 410 from a directory in storage 111.

Coupling target 2_440 is an item for selecting second component 411 to be coupled. For example, the user may select pull-down of coupling target 2_440 and select second component 411 from a list, or select CAD data of second component 411 from the directory in storage 111.

Coupling point 450 is an item for setting the coordinates of a location of coupling between first component 410 and second component 411. In an aspect, coupling point 450 may include only one coordinate or may include two or more coordinates. For example, coupling point 450 can include a central axis of a screw hole, a position at which a surface of first component 410 is in contact with a surface of second component 411, a direction of sliding of a sliding component, or the like. The user can operate tool 420 with a mouse, a touch panel, or the like on 3D display screen 402 to select coupling point 450. The user may directly input coordinates to coupling point 450.

Method of connecting coupling portions 460 is an item for setting the type of connection between first component 410 and second component 411. For example, method of connecting coupling portions 460 can include any connection method such as a slider j oint, a hinge joint, a pole joint, a rotary joint, and a fixed joint.

Distance of movement 470 is an item for setting a range of the distance of movement of first component 410 (movable component). The user can appropriately change distance of movement 470 based on an execution result of a test operation of the assembly, which will be described later with reference to Figs. 14 to 16.

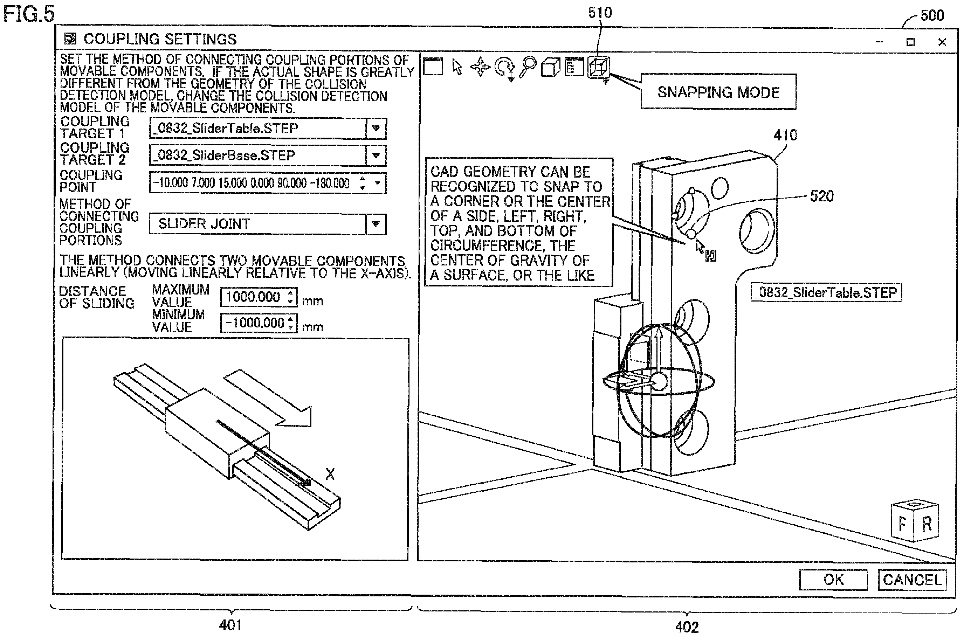

Fig. 5 shows an example snapping mode on the coupling setting screen. A coupling setting screen 500 is a screen when a snapping mode 510 is enabled on coupling setting screen 400. In snapping mode 510, the cursor snaps to a specific location of the component. The specific location is, for example, an edge of a rectangle, the circumference of a circle, the center of a circle, or the like. The user can enable snapping mode 510 to easily select a location that is likely to be a coupling point, such as the center of a screw hole. In the example shown in Fig. 5, the cursor is snapped to a point 520 on the outer circumference of a screw hole of first component 410.

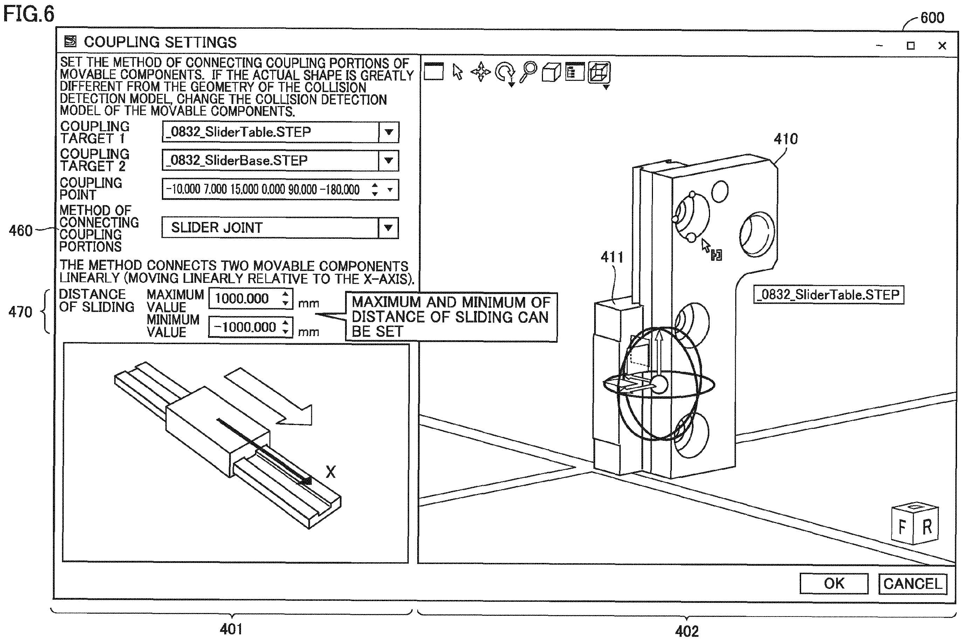

Fig. 6 shows a first setting example on the coupling setting screen. A coupling setting screen 600 displays connection settings of first component 410 and second component 411 described above. On coupling setting screen 600, a slider joint is selected as method of connecting coupling portions 460. Also, input items for distance of movement 470 are a maximum value and a minimum value of a distance of sliding.

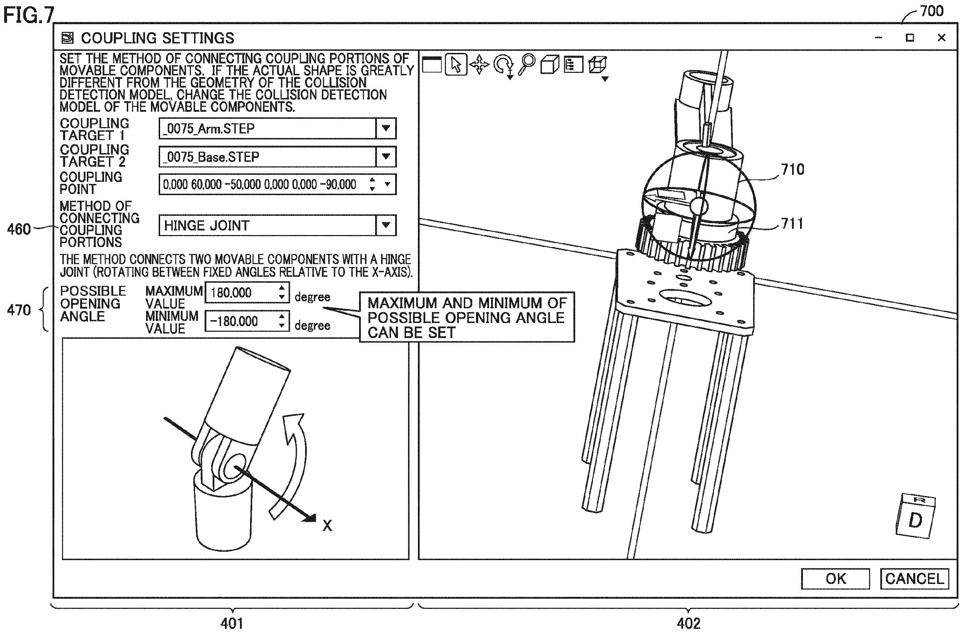

Fig. 7 shows a second setting example on the coupling setting screen. A coupling setting screen 700 displays connection settings of a first component 710 and a second component 711. On coupling setting screen 700, a hinge joint is selected as method of connecting coupling portions 460. Also, input items for distance of movement 470 are a maximum value and a minimum value of a possible opening angle.

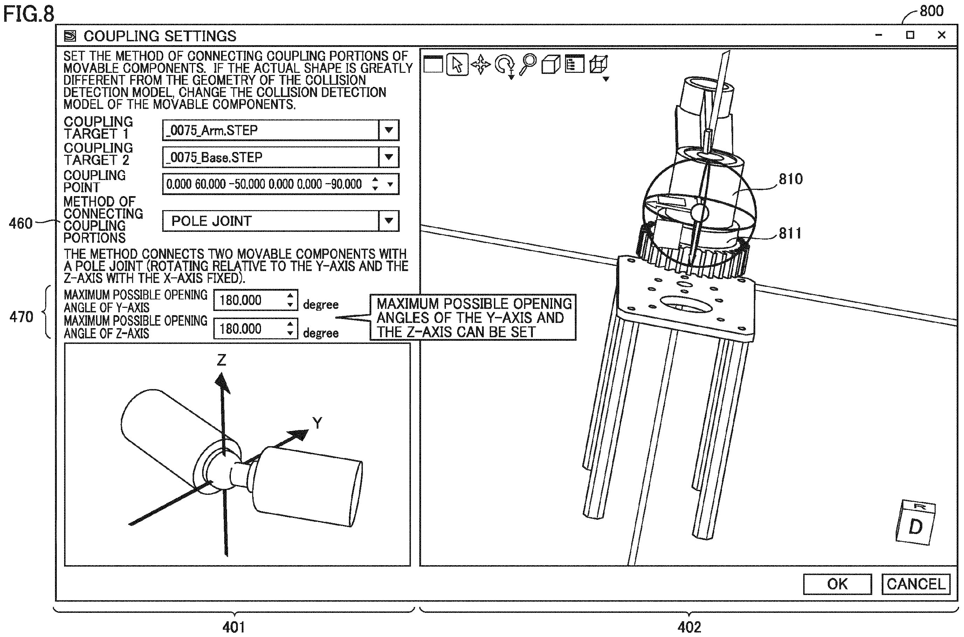

Fig. 8 shows a third setting example on the coupling setting screen. A coupling setting screen 800 displays connection settings of a first component 810 and a second component 811. For first component 810 and second component 811, a joint portion is a pole joint unlike first component 710 and second component 711. On coupling setting screen 800, a pole joint is selected as method of connecting coupling portions 460. Also, input items for distance of movement 470 are a maximum possible opening angle of the Y-axis and a maximum possible opening angle of the Z-axis.

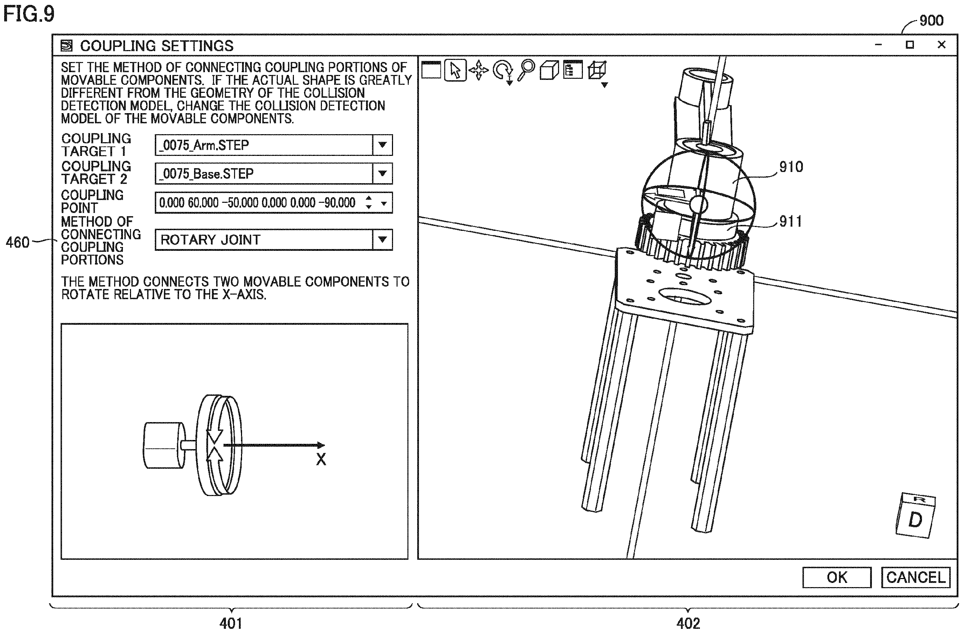

Fig. 9 shows a fourth setting example on the coupling setting screen. A coupling setting screen 900 displays connection settings of a first component 910 and a second component 911. For first component 910 and second component 911, a joint portion is a rotary joint unlike first component 710 and second component 711. On coupling setting screen 900, a rotary joint is selected as method of connecting coupling portions 460. For a rotary joint, the distance of movement has no limit, and accordingly, input items for distance of movement 470 are not displayed.

### <D. Motion Direction Settings>

Next, the motion direction setting function and a UI therefor, which are provided by system 100, will be described with reference to Figs. 10 to 13. The user can set a direction of motion of a first component via a motion direction setting screens described with reference to Figs. 10 to 13.

Fig. 10 shows an example motion direction setting screen. A motion direction setting screen 1000 includes a motion direction setting input panel 1001 and a 3D display screen 1002. On 3D display screen 1002, a first component 1010 and a second component 1011 having a coupling relationship, and tools 1003, 1004 for setting the direction of motion of first component 1010 are displayed. The user can set the direction of motion of first component 1010 by dragging or selecting tool 1003 or rotating tool 1004 with a mouse or the like.

Motion direction setting input panel 1001 relates to settings of the direction of motion of first component 1010. Motion direction setting input panel 1001 includes, as setting items, a component name 1020, a motion type 1030, a motion direction adjustment 1040, and a motion check input 1050.

Component name 1020 is an item for selecting a component that is movable. In the example of Fig. 10, first component 1010 is selected.

Motion type 1030 is an item for selecting the type of a motion of first component 1010. The motion type can include any motion such as linear motion, rotation, and a combined motion of linear motion and rotation. In an aspect, the item for motion type 1030 may be automatically selected based on the setting of method of connecting coupling portions 460 on a coupling setting screen.

Motion direction adjustment 1040 is an item for adjusting the direction of motion of first component 1010 and may include a plurality of coordinates (e.g., starting and end points of the direction of linear motion, two points indicating an axis of rotation) for representing a motion. The user may directly input a numerical value to motion direction adjustment 1040. The user may also drag or select tool 1003 or rotate tool 1004 with a mouse or the like to adjust a numerical value of motion direction adjustment 1040.

Motion check input 1050 is an item for checking a motion of first component 1010. The user can check a motion of first component 1010 on 3D display screen 1002 by, for example, inputting coordinates to motion check input 1050 or moving a slider displayed in motion check input 1050. The contents displayed in motion check input 1050 can be changed according to a motion selected in motion type 1030.

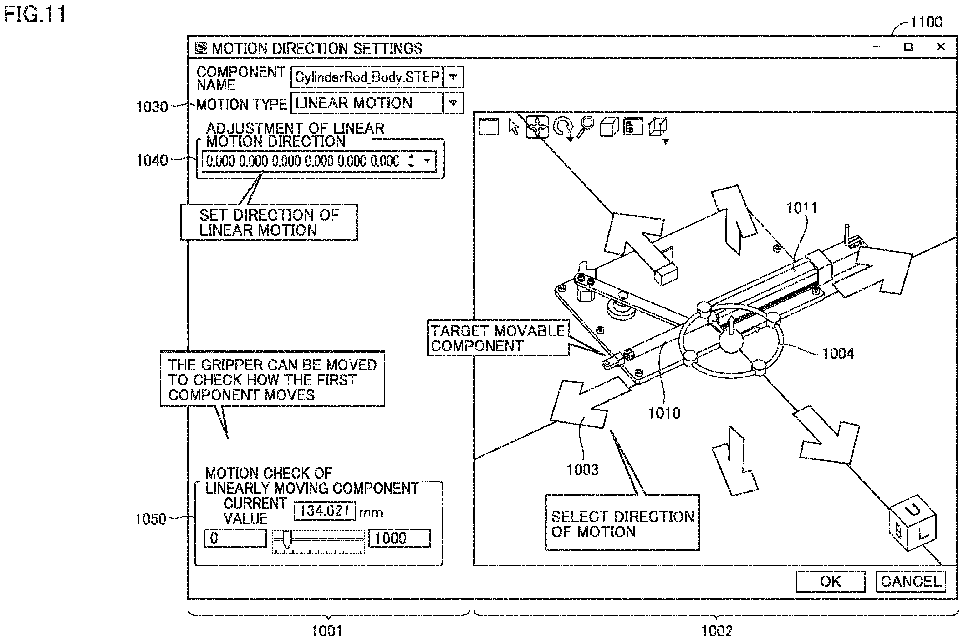

Fig. 11 shows a first setting example on the motion direction setting screen. A motion direction setting screen 1100 displays motion direction settings of first component 1010 described above. On motion direction setting screen 1100, linear motion is selected as motion type 1030. Also, the direction in which first component 1010 linearly moves (which is adjustable by tools 1003, 1004) is set as motion direction adjustment 1040. A slider indicating the distance of linear motion of first component 1010 and input boxes for an upper limit and a lower limit of the slider are displayed as motion check input 1050. The user can move a gripper of the slider to check a motion of first component 1010. The user can also change the upper limit and the lower limit of the slider to change a motion range of first component 1010.

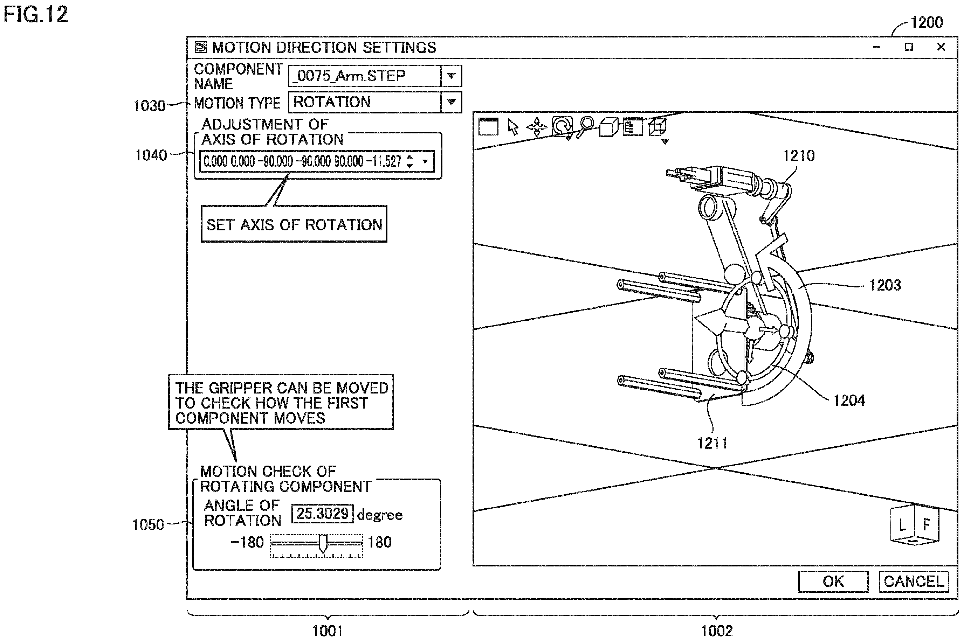

Fig. 12 shows a second setting example on the motion direction setting screen. On 3D display screen 1002, a first component 1210 and a second component 1211 having a coupling relationship, and tools 1203, 1204 for setting the direction of motion of first component 1210 are displayed. Motion direction setting screen 1200 displays the motion direction settings of first component 1210. On motion direction setting screen 1200, rotation is selected as motion type 1030. Also, the axis of rotation of first component 1210 (which is adjustable by tools 1203, 1204) is set as motion direction adjustment 1040. A slider that indicates an angle of rotation of first component 1210 is displayed as motion check input 1050. The user can move the gripper of the slider to check a motion of first component 1210.

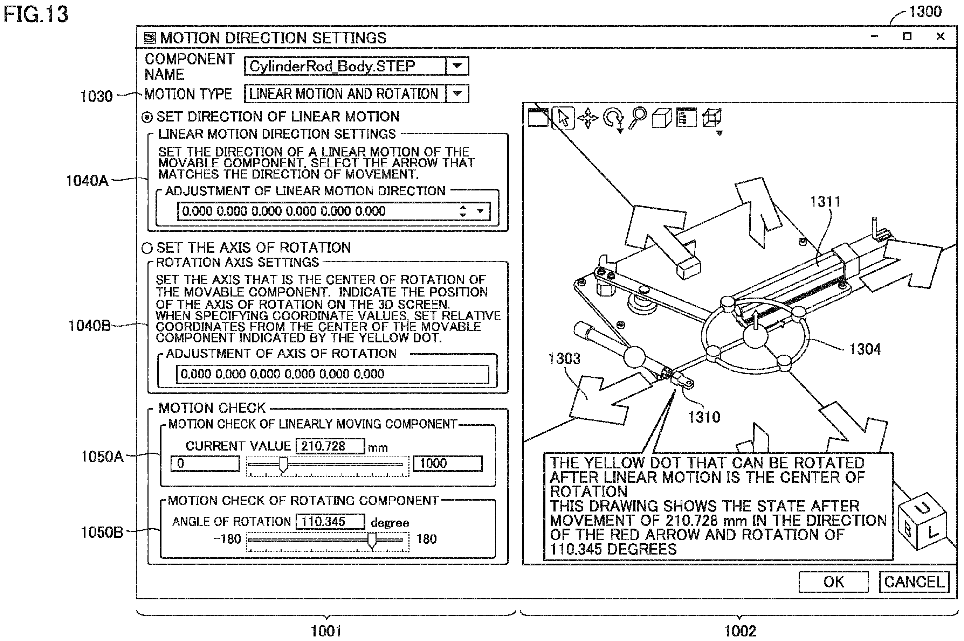

Fig. 13 shows a third setting example on the motion direction setting screen. On 3D display screen 1002, a first component 1310 and a second component 1311 having a coupling relationship, and tools 1303, 1304 for setting the direction of motion of first component 1310 are displayed (the mechanism between the first and second components is omitted). Motion direction setting screen 1300 displays the motion direction settings of first component 1310. On motion direction setting screen 1300, linear motion and rotation is selected as motion type 1030. "Linear motion and rotation" indicates a combined motion including linear motion and rotation. Also, linear motion direction settings 1040A of first component 1310 and rotation axis settings 1040B of first component 1310 are set as motion direction adjustment 1040. Both the direction of linear motion and the axis of rotation of first component 1310 are adjustable by tools 1303, 1304. A motion check input for linear motion 1050A and a motion check input for rotary motion 1050B are displayed as motion check input 1050. The user can operate motion check input for linear motion 1050A and motion check input for rotary motion 1050B to check a motion of first component 1310.

### <E. Test Operation of Assembly>

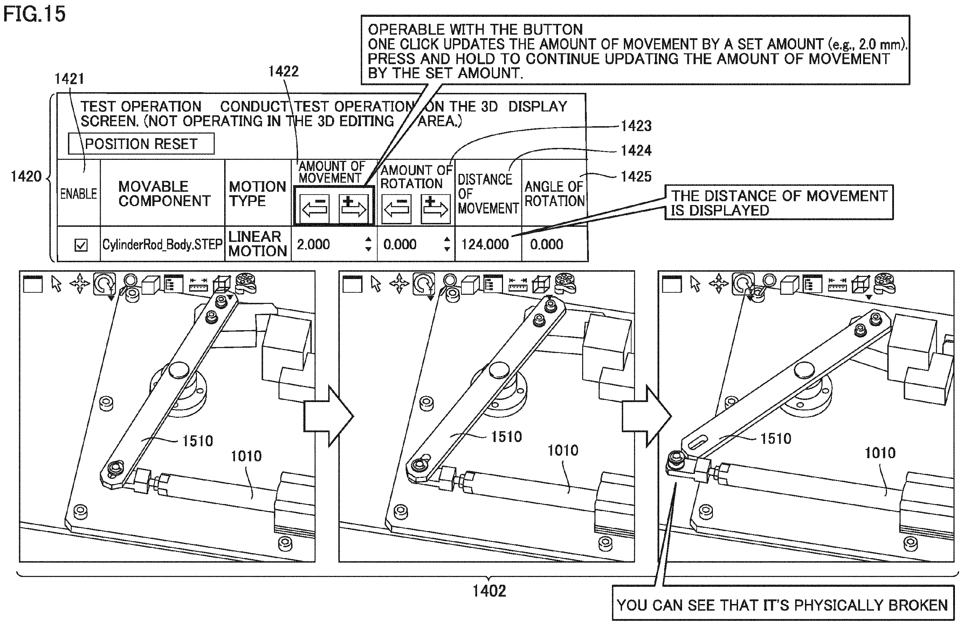

Next, an assembly test operation function and a UI therefor, which are provided by system 100, will be described with reference to Figs. 14 to 16. The user can operate an assembly via a test operation screen described with reference to Figs. 14 and 15.

Fig. 14 shows an example assembly test operation screen. A test operation screen 1400 includes a test operation input panel 1401 and a 3D display screen 1402. On 3D display screen 1402, the assembly including first component 1010 and second component 1011 described with reference to Fig. 10 is displayed. Test operation input panel 1401 includes a test operation setting panel 1420. Test operation setting panel 1420 includes, as input items, a test operation function enabling/disabling change 1421, an amount of movement 1422, and an amount of rotation 1423. Test operation setting panel 1420 can display a distance of movement 1424 of a current movable component and an amount of rotation 1425 of the current movable component. The user can input, for example, test operation function enabling/disabling change, and a distance of movement of linear motion and an amount of rotation of a movable component via test operation setting panel 1420. Further, the movable component (in the example of Fig. 14, first component 1010) on 3D display screen 1402 operates based on an input value in test operation setting panel 1420.

Fig. 15 shows an example use of the assembly test operation screen. The user can update a value of amount of movement 1422 to gradually move first component 1010, which is a movable component. As the value of amount of movement 1422 changes, the position of first component 1010, which is a movable component on 3D display screen 1402, also changes. In the example of Fig. 15, first component 1010 is disconnected from another component 1510 as first component 1010 operates by a certain amount or more. This display indicates that the assembly will be damaged as first component 1010 moves by a certain amount or more. In this manner, on the test operation screen, the user can check the overall motion of the assembly by operating the movable component and can also check an amount by which the movable component is operated to damage the assembly.

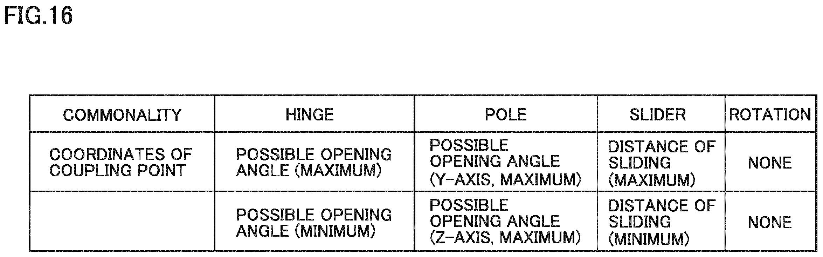

Fig. 16 shows example coupling settings set in system 100. The user can input coupling settings of the assembly to system 100 via, for example, screens shown in Figs. 4 to 15. The coupling settings include "coordinates of a coupling point" that are common irrespective of the type of coupling. The coupling settings include information for each type of coupling. For example, the coupling settings include "possible opening angle (maximum, minimum)" for a hinge joint, "possible opening angle (maximum of Y-axis, maximum of Z-axis)" for a pole joint, and "distance of sliding (maximum, minimum)" for a slider joint.

### <F. Controller Setting Function and Simulation Function>

Next, a controller setting function, a simulation function (a simulation function with physical engine 158 and a controller emulator coordinated with each other), and a UI for these functions, which are provided by system 100, will be described with reference to Figs. 17 and 18.

Fig. 17 shows an example simulation execution screen. Simulation execution screens 1700A, 1700B, 1700C indicate transitions of the simulation execution screen.

In the example of Fig. 17, the assembly coupling settings and the controller settings have been completed, and system 100 performs a simulation with physical engine 158 and the controller emulator coordinated with each other. The user can perform, for example, connection settings of each IO of the controller in advance via the UI provided by system 100. Controller emulator 159 can emulate an input/output signal of each IO based on the controller settings.

The simulation execution screen includes a controller panel 1701 and a 3D display screen 1702. Controller panel 1701 includes information on controllers connected to an assembly, which is to be simulated, via a motor or the like. The user can select, via controller panel 1701, a controller that is coordinated with physical engine 158. The controller selected herein is, for example, an object file or the like of a controller whose operation is simulated by controller emulator 159.

Controller panel 1701 includes at least an IO signal panel 1710. IO signal panel 1710 shows a signal state of each IO included in the controller coordinated with physical engine 158. Blocks shown in Fig. 17 respectively correspond to IOs. For example, when a first IO is used as an output port, the user can select the block of the first IO to change ON/OFF of an output signal of the block of the first IO. For example, when a second IO is used as an input port, display (indicating ON/OFF) of the block of the second IO is updated upon change in a signal input to the second IO.

Next, example coordination between physical engine 158 and controller emulator 159 will be described by taking transitions of execution screens 1700A, 1700B, 1700C as an example. In the example of Fig. 17, a simulation target is an assembly including first component 1010 and second component 1011 described with reference to Fig. 10.

Execution screens 1700A, 1700B, 1700C show a sequence of events from operating an assembly (more specifically, first component 1010) by the controller via a motor to obtaining, from a sensor by the controller, a signal indicating that first component 1010 has reached a predetermined end position.

On execution screen 1700A, as the user clicks the block of IO "1" on IO signal panel 1710, the signal of IO "1" of an IO controller has been turned on. When IO " 1" is an input port, controller emulator 159 can detect that the signal of IO "1" of the controller has been turned on. It is assumed here that the user program includes a process of outputting a command to a motor driver upon turn-on of the signal of IO "1". In this case, controller emulator 159 outputs a command to a motor driver connected to a motor that operates an assembly, upon turn-on of the signal of IO "1" of the controller.

On execution screen 1700B, the motor driver that has received the command outputs a driving signal to the motor. Physical engine 158 simulates a motion of the motor and a motion of the assembly operated by the motor, upon the driving signal being output to the motor. In other words, physical engine 158 simulates a linear motion of first component 1010.

In an aspect, the motions of the motor driver and the motor may be emulated by controller emulator 159. In this case, physical engine 158 obtains information on an amount of the motion of the motor from controller emulator 159 and simulates a motion of the assembly that is operated by the motor.

In another aspect, the motions of the motor driver and the motor may be simulated by physical engine 158. In this case, physical engine 158 obtains a command to the motor driver from controller emulator 159 and simulates the motion of the motor and the motion of the assembly that is operated by the motor.

In still another aspect, the motion of the motor driver may be emulated by controller emulator 159, and the motion of the motor may be simulated by physical engine 158. In this case, physical engine 158 obtains, from controller emulator 159, a driving signal output from the motor driver and simulates the motion of the motor and the motion of the assembly that is operated by the motor.

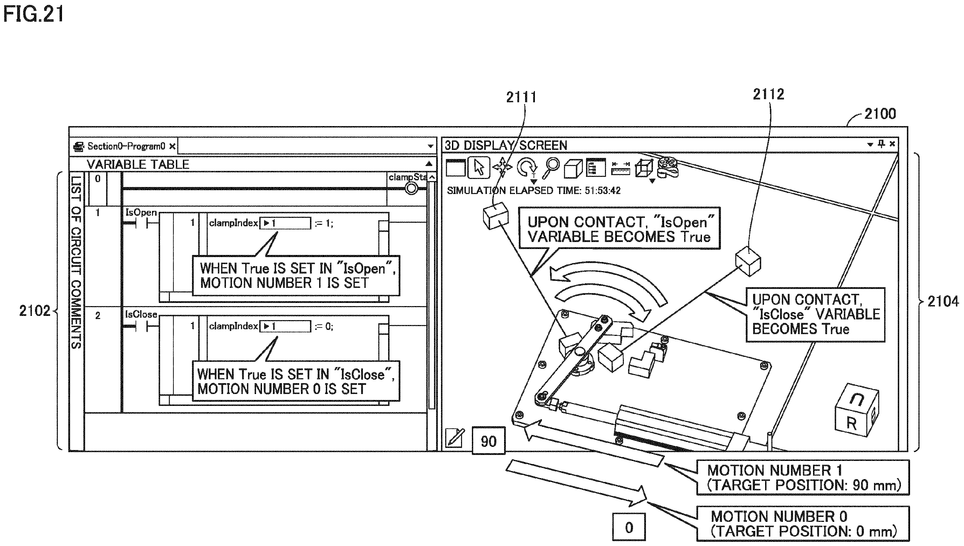

On execution screen 1700C, the signal of IO "2" on IO signal panel 1710 is ON. For example, it is assumed that IO "2" is set as an input port by the user program and IO "2" is connected to the virtual sensor (see virtual sensors 2111, 2112 in Fig. 21). In this case, the virtual sensor outputs a signal to IO "2" when first component 1010 reaches the end position. The virtual sensor will be described later in detail with reference to Fig. 21.

As described above, system 100 operates physical engine 158 and controller emulator 159 in coordination with each other based on the controller settings and the assembly coupling settings, and further, the virtual sensor settings. This allows the user to check whether the user program and the assembly operate as intended.

Fig. 18 shows an example motor driver setting screen. System 100 includes a controller IO setting function, as well as a motor driver setting function. Controller emulator 159 can emulate outputting, from a controller to a motor driver, an instruction based on the settings of the motor driver.

A motor driver setting screen 1800 includes, as items, a target controller 1810, and one or more motion settings 1820 (in the example of Fig. 18, a first motion setting 1830 and a second motion setting 1831).

Target controller 1810 is a setting item of the controller that transmits a command to the motor driver. A controller name, a controller identifier, or the like is set in target controller 1810.

Motion settings 1820 are motion settings of the motor driver when receiving a command from the controller. More specifically, motion settings 1820 are settings of, for example, the speed, position, and angle of a servomotor or the like driven by the motor driver. Motion settings 1820 include, as items, a start variable 1840, an end variable 1850, a motion number variable 1860, and a motion pattern 1870.

Start variable 1840 is a variable that triggers the motor driver to start a motion. For example, as the value of start variable 1840 becomes "True" in the user program, the controller transmits a command to the motor driver.

End variable 1850 is a variable indicating that the assembly connected to the motor has reached a target position. The controller may rewrite end variable 1850 in accordance with, for example, a signal output from the sensor which indicates that the assembly has reached a predetermined position. For example, as the value of end variable 1850 becomes "True" in the user program, the controller can transmit a stop command to the motor driver.

Motion number variable 1860 is a variable that identifies motion settings. Motion settings 1820 can include a plurality of motion settings such as first motion setting 1830 and second motion setting 1831. The user program can specify a motion number in motion number variable 1860, thereby appropriately selecting a motion setting to be used.

Motion pattern 1870 defines the contents of the motion of a motor driven by the motor driver or an assembly operated by the motor. Motion pattern 1870 can register a combination of one or more motions. Each motion can include, as elements, speed (rotation speed), position, angle, and the like.

In an aspect, system 100 may incorporate a code based on the settings of setting screen 1800 of the motor driver into the user program when the user program is built.

### <G. Debug Function>

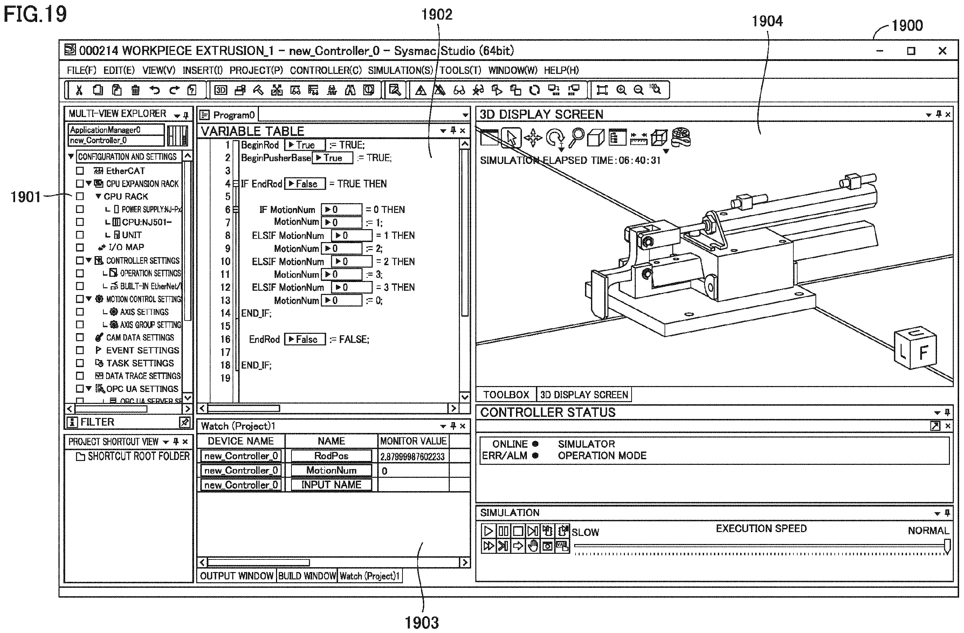

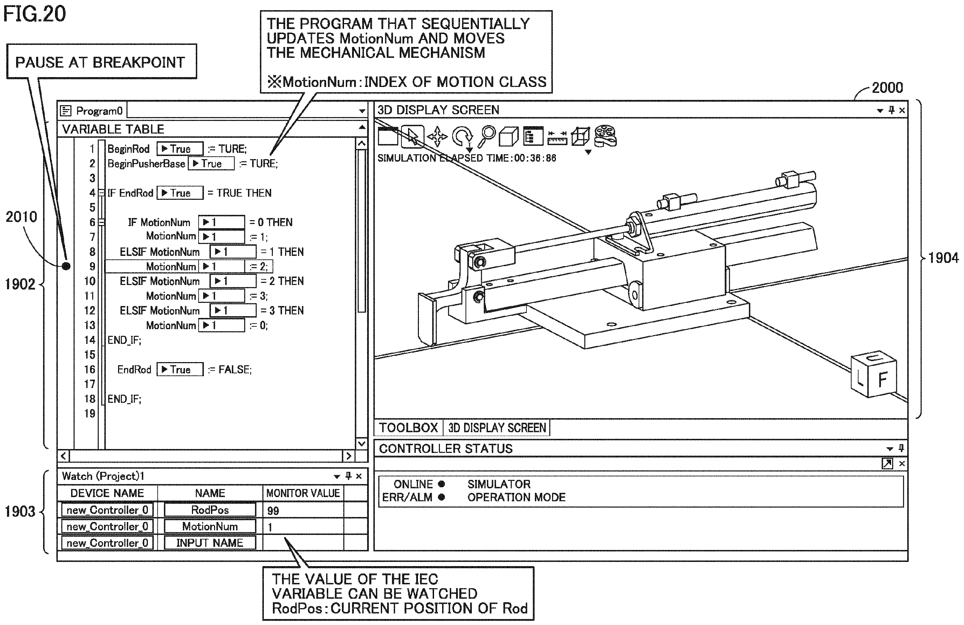

Next, the debug function provided by system 100 will be described with reference to Figs. 19 and 20.

Fig. 19 shows a first example of a debug screen of the user program. Referring to a debug screen 1900, the user can debug the user program while checking a motion of the assembly.

Debug screen 1900 includes an explorer 1901, a code editor 1902 of the user program, a watch window 1903, and a 3D display screen 1904. In an aspect, debug screen 1900 may include any other display item.

Explorer 1901 is a display for selecting various settings such as settings of a controller, settings of a network, and settings of expansion equipment.

Code editor 1902 of the user program displays the user program. Code editor 1902 of the user program can display a current value of each variable included in the user program. In an aspect, the screen of the user program code and the screen of the current value of each variable may be separated from each other.

Watch window 1903 displays information on a variable specified by the user. For example, the user can use watch window 1903 to track changes in the value of a particularly important variable.

3D display screen 1904 displays a motion of the assembly. The motion of the assembly on 3D display screen 1904 is in conjunction with the behavior of the user program. In other words, code editor 1902 of the user program represents an execution status (a value of each variable in a currently performed step) of the current user program, and 3D display screen 1904 represents the state of the assembly operated by the current user program or the state of the assembly corresponding to each step of the user program. The user can check both the user program and the state of the assembly to check an operation of the production line in an environment close to the reality.

Fig. 20 shows a second example of the debug screen of the user program. A debug screen 2000 shows the state in which a breakpoint function is used on debug screen 1900.

The user can set a breakpoint 2010 in a specific row (also referred to as step) on code editor 1902 of the user program. When the user program is executed with breakpoint 2010 set, the user program pauses at the breakpoint. Also, system 100 pauses a motion of the assembly in the state corresponding to the breakpoint of the user program. Further, watch window 1903 displays a value of a variable to be watched at the breakpoint.

For example, the user can easily find a defect in a program or an assembly by setting breakpoint 2010 at or immediately before a step at which a problem has presumably occurred on the user program and checking the value of each variable at the breakpoint and the operating state of the assembly.

In an aspect, system 100 may include a function of executing a user program and an assembly motion simulation step by step. Alternatively, system 100 may include the function of reversely playing back, or the function of reversely playing back step by step, the execution of the user program and the motion simulation of the assembly.

### <H. Virtual Sensor>

Next, the virtual sensor setting function and a UI therefor, which are provided by system 100, will be described with reference to Fig. 21. Various sensors are often placed in a current FA production line. Thus, in order to simulate an assembly in an environment closer to reality, it is desirable that a virtual sensor that outputs a signal to controller emulator 159 be placed also in the 3D space. Therefore, system 100 provides the function of placing a virtual sensor in the 3D space as will be described below.

Fig. 21 shows an example setting screen of the virtual sensor. The user can place a virtual sensor in the 3D space via a setting screen 2100 of the virtual sensor and also describe the process related to the virtual sensor in the user program. Controller emulator 159 can emulate an input signal of the virtual sensor based on the settings of the virtual sensor.

Setting screen 2100 of the virtual sensor includes a code editor 2102 of the user program and a 3D display screen 2104. The user can place any number of virtual sensors on 3D display screen 2104. In the example of Fig. 21, virtual sensors 2111, 2112 are placed on 3D display screen 2104. The virtual sensor can represent an area to which a sensor responds using lines, blocks, or the like. For example, when the assembly contacts a line of virtual sensor 2111, the value of variable "IsOpen" becomes "True". When the assembly contacts a line of virtual sensor 2112, the value of variable "IsClose" becomes "True". In addition, system 100 also receives an input of the connection relationship between the virtual sensor and the IO of the controller.

Further, the user can describe the code related to the virtual sensor placed on 3D display screen 2104 in code editor 2102 of the user program. For example, the user can describe a code for executing a process upon the value of variable "IsOpen" becoming "True". The user can also describe a code for executing another process upon the value of variable "IsClose" becoming "True".

The user can place the virtual sensor in the 3D space via setting screen 2100 of the virtual sensor and also describe the process related to the virtual sensor in the user program, thereby verifying the user program and the motion of the assembly in an environment closer to reality.

### <I. Flowchart>

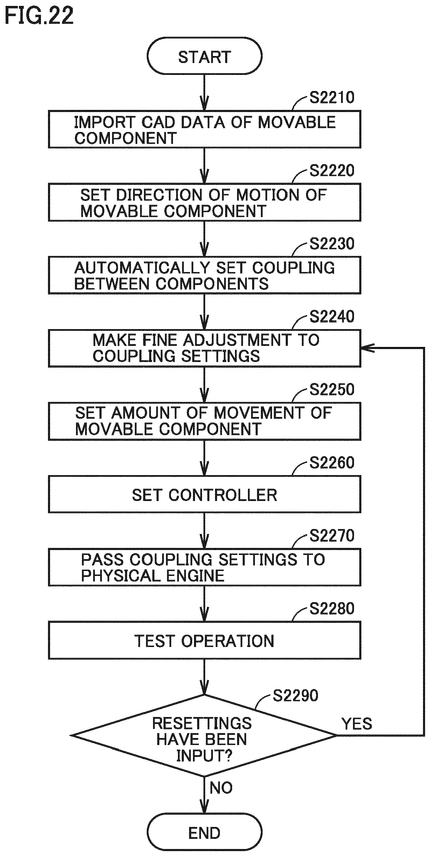

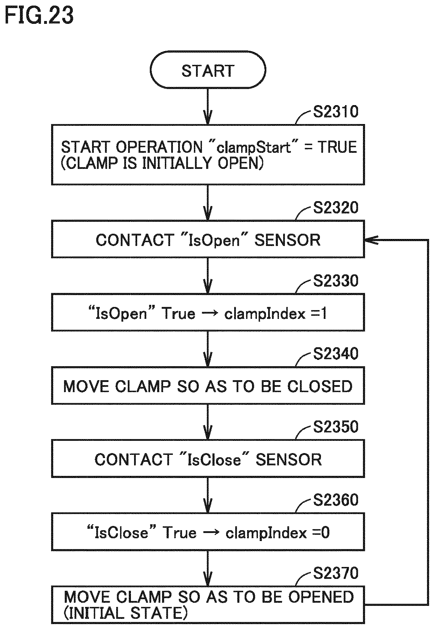

Next, the procedure of system 100 will be described with reference to Figs. 22 and 23. In an aspect, processor 102 may read the program (e.g., integrated development environment 130) for performing the processes of Figs. 22 and 23 from storage 111 into main memory 104 and execute the program. In another aspect, some or all of the processes can be implemented also as a combination of circuit elements configured to perform the processes. In still another example, the order of performing the steps is interchangeable as appropriate. For example, the order of the processes based on a user's operation input can change according to the order in which the user performs the operations.

Fig. 22 is a flowchart showing an example series of processes from generation of various settings to execution of a simulation in system 100.

In step S2210, system 100 imports CAD data of a movable component. More specifically, when system 100 is provided as a device, system 100 can import CAD data stored in storage 111 into integrated development environment 130 based on a user's operation. When system 100 is provided as a cloud service, system 100 can import the CAD data obtained via a browser of a user terminal or the like into integrated development environment 130. In an aspect, system 100 may import CAD data including an assembly composed of a plurality of components. In another aspect, system 100 may individually import component-by-component CAD data.

In step S2220, system 100 sets the direction of motion of the movable component. More specifically, system 100 can receive an input of setting of the direction of motion of the movable component from the user via the motion direction setting screen described with reference to Figs. 10 to 13. System 100 sets the direction of motion of the movable component based on the received input of the setting of the direction of motion.

In step S2230, system 100 automatically sets coupling between components. For example, system 100 can automatically set coupling between components based on the motion direction setting of each movable component and the shape of each component.

In step S2240, system 100 makes fine adjustment to the coupling settings between components. More specifically, system 100 can receive an input of the coupling settings of the movable component from the user via the coupling setting screens described with reference to Figs. 4 to 9. System 100 makes fine adjustment to the coupling settings between components based on the received input of the coupling settings. Examples of fine adjustment to the coupling settings between components can include adjustment of a coupling point and selection of the type of coupling.

In step S2250, system 100 sets an amount of movement of the movable component. More specifically, system 100 can receive an input of the motion range or the amount of movement of the movable component from the user via the coupling setting screens described with reference to Figs. 4 to 9. System 100 sets the amount of movement of the movable component based on the received input of the settings of the motion range or the amount of movement. In an aspect, the process of step S2250 may include a process of receiving an operation of checking an assembly-by-assembly motion from the user via the screens described with reference to Figs. 14 and 15.

In step S2260, system 100 sets a controller. More specifically, system 100 can receive an operation input from the user via the setting screen of the controller and set the controller. In an aspect, the process of step S2260 may include the process of receiving an operation of setting a motor driver from the user via the screen described with reference to Fig. 15.

In step S2270, system 100 passes coupling settings to physical engine 158. In an aspect, the process of step S2270 may include a process of passing the settings of the controller and the settings of the motor driver to controller emulator 159.

In step S2280, system 100 performs a test operation. More specifically, system 100 can perform a simulation with physical engine 158 and controller emulator 159 coordinated with each other. The user can check an operation of the controller (a change in signal of each IO) and a motion of the assembly via, for example, the screen described with reference to Fig. 17.

In step S2290, system 100 determines whether resettings related to the coupling settings or the controller settings have been input. When determining that resettings related to the coupling settings or the controller settings have been input (YES in step S2290), system 100 moves control to step S2240. Otherwise (NO in step S2290), system 100 ends the process. The process of step S2290 is merely an example, and system 100 may move control to any of the processes of step S2210 to step S2270 according to an operation such as changing the settings received from the user.

Fig. 23 is a flowchart showing an example procedure of a simulation using a virtual sensor in system 100. The processes shown in Fig. 23 represent the procedure of a simulation when the settings of the virtual sensor described with reference to Fig. 21 are used. The assembly shown in Fig. 21, which is a clamp mechanism, performs an operation of opening a clamp once and then closing the clamp to clamp a workpiece.

The following processes will be described mainly in terms of a controller, and the controller performs the following processes based on an installed user program. The operation of the controller is actually emulated by controller emulator 159. The motion of the assembly operated by the controller is simulated by physical engine 158.

In step S2310, the controller starts an operation. More specifically, upon turn-on of the signal of IO "1", the controller operates the assembly via the motor driver. At this time, the clamp (assembly) is open.

In step S2320, the controller detects that the assembly has contacted the virtual sensor (variable) "IsOpen".

In step S2330, the controller sets the value of a variable "clampIndex" to "1" upon the value of variable "IsOpen" becoming "True". For example, variable "clampIndex=1" indicates that the clamp is open to a predetermined position.

In step S2340, the controller moves the clamp so as to be closed. More specifically, the controller transmits, to the motor driver, a command to change the direction of rotation of the motor.

In step S2350, the controller detects that the assembly has contacted virtual sensor (variable) "IsClose".

In step S2360, the controller sets the value of variable "clampIndex" to "0" upon the value of variable "IsClose" becoming "True". For example, variable "clampIndex=0" indicates that the clamp is closed to a predetermined position (a position at which a workpiece is clamped).

In step S2370, the controller moves the clamp so as to be opened (initial state). More specifically, the controller transmits, to the motor driver, a command to change the direction of rotation of the motor.

As described above, system 100 according to the present embodiment can coordinate physical engine 158 with controller emulator 159 to verity the user program and the motion of the assembly.

Also, system 100 can provide the function of adjusting the coupling settings of the assembly to set, for example, the coupling point, the direction of motion, and the type of motion, which are difficult to determine only from the shape of the component, in detail.

Also, system 100 can provide the function of setting a controller, the function of simultaneously displaying a program execution status and a simulation screen, and the debug function (such as a step execution function, a breakpoint function) to perform debugging while checking a motion of the assembly and a value of a variable of the program.

Further, system 100 can provide the function of placing a virtual sensor in a simulation to perform a simulation closer to a real environment.

The technique of the present disclosure can be implemented by any means such as a cloud service that provides the functions of system 100, distributable software that operates standalone, and a personal computer with installed software that provides the functions of system 100.

### <J. Additional Aspects>

As described above, the present embodiment includes the following disclosure.

### [Configuration 1]

A program for a simulation, the program causing a computer (300) to:
obtain a plurality of pieces of component data of an assembly;
generate a coupling setting between pieces of component data of the plurality of pieces of component data;
receive an operation input from a user;
adjust the coupling setting based on the operation input from the user;
emulate, based on a user program, a controller configured to control the assembly; and
operate the assembly in a three-dimensional (3D) space,
wherein operating the assembly includes operating, based on the adjusted coupling setting, the pieces of component data of the plurality of pieces of component data in conjunction with each other.

### [Configuration 2]

The program according to configuration 1, wherein adjusting the coupling setting includes
selecting a type of coupling between the pieces of component data of the plurality of pieces of component data,
adjusting a coupling point, and
setting a direction of motion of a first component included in the plurality of pieces of component data.

### [Configuration 3]

The program according to configuration 1 or 2, further causing the computer (300) to snap, on a screen configured to receive the operation input from the user, a cursor to a location of each of the plurality of pieces of component data in the 3D space.

### [Configuration 4]

The program according to configuration 3, further causing the computer (300) to receive an input of an amount of movement of a movable component included in the assembly,
wherein operating the assembly includes operating, on a screen for a test operation of the assembly, each of the plurality of pieces of component data in the 3D space upon input of the amount of movement of the movable component included in the assembly.

### [Configuration 5]

The program according to any one of configurations 1 to 4, further causing the computer (300) to receive a setting of each of a plurality of interfaces of the controller, wherein
the setting of each of the plurality of interfaces includes a setting of a device, a machine, or a sensor connected with each of the plurality of interfaces, and
emulating the controller includes emulating an input/output signal of each of the plurality of interfaces based on the setting of each of the plurality of interfaces.

### [Configuration 6]

The program according to any one of configurations 1 to 5, further causing the computer (300) to receive a motion setting of a motor driver controlled by the controller,
wherein emulating the controller includes outputting an instruction corresponding to the motion setting from the controller to the motor driver.

### [Configuration 7]

The program according to any one of configurations 1 to 6, further causing the computer (300) to receive an input of a setting of a virtual sensor, wherein
the setting of the virtual sensor includes
   information on placement of the virtual sensor in the 3D space, and
   information on connection between the virtual sensor and an interface of the controller, and
emulating the controller includes emulating an input signal of the virtual sensor in the controller based on the setting of the virtual sensor.

### [Configuration 8]

The program according to any one of configurations 1 to 7, further causing the computer (300) to display an execution result of the user program by an emulation and an execution result of a simulation,
wherein displaying the execution result of the user program by the emulation and the execution result of the simulation includes displaying an execution result of each step of the user program and an execution result of a simulation corresponding to each step of the user program.

### [Configuration 9]

The program according to configuration 8, further causing the computer (300) to:
receive an input to set a breakpoint in the user program; and
display an execution result of a simulation corresponding to the breakpoint upon stop of the user program at the breakpoint.

### [Configuration 10]

A simulation system (100) for a motion of an assembly, the simulation system comprising:
a component acquisition unit (152) configured to obtain a plurality of pieces of component data of an assembly;
an automatic coupling unit (153) configured to generate a coupling setting between pieces of component data of the plurality of pieces of component data;
an operation input unit (151) configured to receive an operation input from a user;
a coupling adjustment unit (154) configured to adjust the coupling setting based on the operation input from the user;
an emulator (159) of a controller configured to control the assembly based on a user program; and
a physical engine (158) configured to operate the assembly in a three-dimensional (3D) space,
wherein the physical engine (158) operates, based on the coupling setting adjusted by the coupling adjustment unit (154), the pieces of component data of the plurality of pieces of component data in conjunction with each other.

### [Configuration 11]

The simulation system (100) according to configuration 10, wherein adjusting the coupling setting includes
selecting a type of coupling between the pieces of component data of the plurality of pieces of component data,
adjusting a coupling point, and
setting a direction of motion of a first component included in the plurality of pieces of component data.

### [Configuration 12]

The simulation system (100) according to configuration 10 or 11, wherein the operation input unit (151) is configured to snap a cursor to a location of each of the plurality of pieces of component data in the 3D space.

### [Configuration 13]

The simulation system (100) according to configuration 12, wherein
the operation input unit (151) is configured to receive an input of an amount of movement of the assembly, and
the physical engine (158) is configured to operate, on a screen for a test operation of the assembly, each of the plurality of pieces of component data in the 3D space upon input of the amount of movement of the assembly.

### [Configuration 14]

The simulation system (100) according to any one of configurations 10 to 13, wherein
the operation input unit (151) is configured to receive a setting of each of a plurality of interfaces of the controller,
the setting of each of the plurality of interfaces includes a setting of a device, a machine, or a sensor connected with each of the plurality of interfaces, and
the emulator (159) is configured to emulate an input/output signal of each of the plurality of interfaces based on the setting of each of the plurality of interfaces.

### [Configuration 15]

The simulation system (100) according to any one of configurations 10 to 14, wherein
the operation input unit (151) is further configured to receive a motion setting of a motor driver controlled by the controller, and
the emulator (159) is configured to output an instruction corresponding to the motion setting from the controller to the motor driver.

### [Configuration 16]

The simulation system (100) according to any one of configurations 9 to 15, wherein
the operation input unit (151) is configured to receive an input of a setting of a virtual sensor,
the setting of the virtual sensor includes
   information on placement of the virtual sensor in the 3D space, and
   information on connection between the virtual sensor and an interface of the controller, and
the emulator (159) is configured to emulate an input signal of the virtual sensor in the controller based on the setting of the virtual sensor.

### [Configuration 17]

The simulation system (100) according to any one of configurations 10 to 16, further comprising a display unit configured to display an execution result of the user program by the emulator (159) and an execution result of a simulation by the physical engine (158),
wherein the display unit is configured to display an execution result of each step of the user program and an execution result of a simulation corresponding to each step of the user program.

### [Configuration 18]

The simulation system (100) according to configuration 17, wherein
the operation input unit (151) is configured to receive an input to set a breakpoint in the user program; and
the display unit is configured to display an execution result of a simulation corresponding to the breakpoint upon stop of the user program at the breakpoint.

It should be appreciated that the embodiments disclosed herein are illustrative in every sense and are not limitative. The scope of the present disclosure is defined by the terms of the claims, rather than the embodiments described above, and is intended to include any modifications within the scope and meaning equivalent to the terms of the claims. Further, it is intended that the contents of the disclosure described in the embodiments and the modification examples can be implemented solely or in combination as much as possible.

### REFERENCE SIGNS LIST

10, 20 assembly; 11, 12, 13, 14, 21, 22, 23, 24, 25, 1510 component; 100 system; 102 processor; 104 main memory; 106 operation unit; 108 output unit; 109 display; 110 network interface; 111 storage; 112 optical drive; 114 recording medium; 116 local communication interface; 130 integrated development environment; 151 operation input unit; 152 component acquisition unit; 153 automatic coupling unit; 154 coupling adjustment unit; 155 motion setting unit; 156 controller setting unit; 157 test operation unit; 158 physical engine; 159 controller emulator; 160 motor driver emulator; 161 display unit; 300 device; 400, 500, 600, 700, 800, 900 coupling setting screen; 401 coupling setting input panel; 402, 1002, 1402, 1702, 1904, 2104 display screen; 410, 710, 810, 910, 1010, 1210, 1310 first component; 411, 711, 811, 911, 1011, 1211, 1311 second component; 420, 1003, 1004, 1203, 1204, 1303, 1304 tool; 430 coupling target 1; 440 coupling target 2; 450 coupling point; 460 method of connecting coupling portions; 470 distance of movement; 510 snapping mode; 1000, 1100, 1200, 1300 motion direction setting screen; 1001 motion direction setting input panel; 1020 component name; 1030 motion type; 1040 motion direction adjustment; 1040A linear motion direction settings; 1040B rotation axis settings; 1050, 1050A, 1050B motion check input; 1400 test operation screen; 1401 test operation input panel; 1420 setting panel; 1421 test operation function enabling/disabling change; 1422 amount of movement; 1423 amount of rotation; 1424 amount of movement of current movable component; 1425 amount of rotation of current movable component; 1700A, 1700B, 1700C execution screen; 1701 controller panel; 1710 signal panel; 1800, 2100 setting screen; 1810 target controller; 1820 motion settings; 1830 first motion setting; 1831 second motion setting; 1840 start variable; 1850 end variable; 1860 motion number variable; 1870 motion pattern; 1900, 2000 debug screen; 1901 explorer; 1902, 2102 code editor; 1903 watch window; 2010 breakpoint; 2111, 2112 virtual sensor.

## Claims

1. A program for a simulation; the program causing a computer to:
obtain a plurality of pieces of component data of an assembly;
generate a coupling setting between pieces of component data of the plurality of pieces of component data;
receive an operation input from a user;
adjust the coupling setting based on the operation input from the user;
emulate, based on a user program, a controller configured to control the assembly; and
operate the assembly in a three-dimensional (3D) space,
wherein operating the assembly includes operating, based on the adjusted coupling setting, the pieces of component data of the plurality of pieces of component data in conjunction with each other.

2. The program according to claim 1, wherein adjusting the coupling setting includes
selecting a type of coupling between the pieces of component data of the plurality of pieces of component data,
adjusting a coupling point, and
setting a direction of motion of a first component included in the plurality of pieces of component data.

3. The program according to claim 1 or 2, further causing the computer to snap, on a screen configured to receive the operation input from the user, a cursor to a location of each of the plurality of pieces of component data in the 3D space.

4. The program according to claim 3, further causing the computer to receive an input of an amount of movement of a movable component included in the assembly,
wherein operating the assembly includes operating, on a screen for a test operation of the assembly, each of the plurality of pieces of component data in the 3D space upon input of the amount of movement of the movable component included in the assembly.

5. The program according to any one of claims 1 to 4, further causing the computer to receive a setting of each of a plurality of interfaces of the controller, wherein
the setting of each of the plurality of interfaces includes a setting of a device, a machine, or a sensor connected with each of the plurality of interfaces, and
emulating the controller includes emulating an input/output signal of each of the plurality of interfaces based on the setting of each of the plurality of interfaces.

6. The program according to any one of claims 1 to 5, further causing the computer to receive a motion setting of a motor driver controlled by the controller,
wherein emulating the controller includes outputting an instruction corresponding to the motion setting from the controller to the motor driver.

7. The program according to any one of claims 1 to 6, further causing the computer to receive an input of a setting of a virtual sensor, wherein
the setting of the virtual sensor includes
information on placement of the virtual sensor in the 3D space, and
information on connection between the virtual sensor and an interface of the controller, and
emulating the controller includes emulating an input signal of the virtual sensor in the controller based on the setting of the virtual sensor.

8. The program according to any one of claims 1 to 7, further causing the computer to display an execution result of the user program by an emulation and an execution result of a simulation,
wherein displaying the execution result of the user program by the emulation and the execution result of the simulation includes displaying an execution result of each step of the user program and an execution result of a simulation corresponding to each step of the user program.

9. The program according to claim 8, further causing the computer to:
receive an input to set a breakpoint in the user program; and
display an execution result of a simulation corresponding to the breakpoint upon stop of the user program at the breakpoint.

10. A simulation system for a motion of an assembly, the simulation system comprising:
a component acquisition unit configured to obtain a plurality of pieces of component data of an assembly;
an automatic coupling unit configured to generate a coupling setting between pieces of component data of the plurality of pieces of component data;
an operation input unit configured to receive an operation input from a user;
a coupling adjustment unit configured to adjust the coupling setting based on the operation input from the user;
an emulator of a controller configured to control the assembly based on a user program; and
a physical engine configured to operate the assembly in a three-dimensional (3D) space,
wherein the physical engine operates, based on the coupling setting adjusted by the coupling adjustment unit, the pieces of component data of the plurality of pieces of component data in conjunction with each other.

11. The simulation system according to claim 10, wherein adjusting the coupling setting includes
selecting a type of coupling between the pieces of component data of the plurality of pieces of component data,
adjusting a coupling point, and
setting a direction of motion of a first component included in the plurality of pieces of component data.

12. The simulation system according to claim 10 or 11, wherein the operation input unit is configured to snap a cursor to a location of each of the plurality of pieces of component data in the 3D space.

13. The simulation system according to claim 12, wherein
the operation input unit is configured to receive an input of an amount of movement of the assembly, and
the physical engine is configured to operate, on a screen for a test operation of the assembly, each of the plurality of pieces of component data in the 3D space upon input of the amount of movement of the assembly.

14. The simulation system according to any one of claims 10 to 13, wherein
the operation input unit is configured to receive a setting of each of a plurality of interfaces of the controller,
the setting of each of the plurality of interfaces includes a setting of a device, a machine, or a sensor connected with each of the plurality of interfaces, and
the emulator is configured to emulate an input/output signal of each of the plurality of interfaces based on the setting of each of the plurality of interfaces.

15. The simulation system according to any one of claims 10 to 14, wherein
the operation input unit is further configured to receive a motion setting of a motor driver controlled by the controller, and
the emulator is configured to output an instruction corresponding to the motion setting from the controller to the motor driver.

16. The simulation system according to any one of claims 10 to 15, wherein
the operation input unit is configured to receive an input of a setting of a virtual sensor,
the setting of the virtual sensor includes
information on placement of the virtual sensor in the 3D space, and
information on connection between the virtual sensor and an interface of the controller, and
the emulator is configured to emulate an input signal of the virtual sensor in the controller based on the setting of the virtual sensor.

17. The simulation system according to any one of claims 10 to 16, further comprising a display unit configured to display an execution result of the user program by the emulator and an execution result of a simulation by the physical engine,
wherein the display unit is configured to display an execution result of each step of the user program and an execution result of a simulation corresponding to each step of the user program.

18. The simulation system according to claim 17, wherein
the operation input unit is configured to receive an input to set a breakpoint in the user program; and
the display unit is configured to display an execution result of a simulation corresponding to the breakpoint upon stop of the user program at the breakpoint.
